# EUROPEAN PATENT APPLICATION

(11) **EP 4 455 223 A1**
(43) Date of publication of application: **30.10.2024**
(21) Application number: 22911327.9
(22) Date of filing: 22.12.2022
(51) Int. Cl.: C08L 83/04, B32B 15/08, B32B 27/00, C08G 77/14

(54) **CURABLE RESIN COMPOSITION, CURED FILM, MULTILAYERED OBJECT, IMAGING DEVICE, SEMICONDUCTOR DEVICE, METHOD FOR PRODUCING MULTILAYERED OBJECT, AND METHOD FOR PRODUCING ELEMENT HAVING JUNCTION ELECTRODE**

(30) Priority: 23.12.2021 JP 2021209413; 23.12.2021 JP 2021209414
(71) Applicant: SEKISUI CHEMICAL CO., LTD., Osaka-shi, Osaka 530-0047 (JP)
(72) Inventor: SHIOJIMA, Taro, Mishima-gun, Osaka 618-0021 (JP); NOMOTO, Hayate, Mishima-gun, Osaka 618-0021 (JP); SATO, Kenichiro, Mishima-gun, Osaka 618-0021 (JP); DEGUCHI, Hidenobu, Mishima-gun, Osaka 618-0021 (JP); SHICHIRI, Tokushige, Mishima-gun, Osaka 618-0021 (JP)
(74) Representative: Cabinet Beau de Loménie
(86) International application number: PCT/JP2022/047302
(87) International publication number: WO 2023/120625

(57) **Abstract**

The present invention aims to provide a curable resin composition that can planarize bonding surfaces and connect elements without leaving surface voids even when the elements have irregularities on the surface, thus imparting high bonding reliability between the elements, a cured film formed using the curable resin composition, a stack including the cured film, an imaging device including the stack, an semiconductor device including the stack, a method for producing the stack, and a method for producing an element including a bonding electrode for use in production of the stack. Provided is a curable resin composition containing: an organosilicon compound; and a solvent, the curable resin composition having a viscosity at 25°C of 2,000 cP or less, the solvent being contained in an amount of 50% by weight or less in the curable resin composition, the curable resin composition having an adhesion of a score of 0 to 2 as measured by a cross-cut method in conformity with JIS K5600-5-6 using a measurement sample obtained by spin-coating a silicon wafer with the composition, evaporating the solvent, and then heat curing at 300°C for one hour to form a film.

## Description

### TECHNICAL FIELD

The present invention relates to a curable resin composition, a cured film formed using the curable resin composition, a stack including the cured film, an imaging device including the stack, a semiconductor device including the stack, a method for producing the stack, and a method for producing an element including a bonding electrode for use in production of the stack.

### BACKGROUND ART

With higher performance of semiconductor devices, 3D stacking of multiple semiconductor chips has been developed. The production of such a stack of multiple semiconductor chips first includes the formation of a bonding surface, which includes copper-made bonding electrodes surrounded by an insulating film, by the damascene process on each of the electrode surfaces of two elements provided with the electrodes. The two elements are then stacked on top of each other such that the bonding electrodes of the bonding surfaces face each other, and then heat-treated to produce a stack (Patent Literature 1).

### CITATION LIST

### - Patent Literature

Patent Literature 1: JP 2006-191081 A

### SUMMARY OF INVENTION

### - Technical problem

In the production of the stack, bonding of the electrodes involves high-temperature treatment at 400°C for four hours. The insulating layers used to form the bonding surfaces thus require high heat resistance. Conventional stacks therefore use insulating inorganic materials such as Si₃N₄ and SiO₂ as the insulating layers. However, insulating layers made of inorganic materials tend to cause warping of the elements. A warped element may cause misalignment of the electrode connecting positions or cracking of electrodes in the stack to be obtained. This may reduce the connection reliability of the stack. As the recent semiconductor devices have higher performance, elements have become larger and thinner, and thus become more susceptible to warping.

With the recent increase in functionality of elements, irregularities with sizes of several to several tens of micrometers may be formed on the element surfaces on which the insulating layers are to be formed. When elements having irregularities are directly bonded, from the standpoint of the connection reliability between electrodes, the wafer surfaces provided with the elements need to be covered with the insulating layers to planarize the bonding surfaces, before the elements are connected to each other. Therefore, there is a demand for materials that can form insulating layers having excellent flexibility and excellent element-planarization properties.

The present invention aims to provide a curable resin composition that can planarize bonding surfaces and connect elements without leaving surface voids even when the elements have irregularities on the surface, thus imparting high bonding reliability between the elements, a cured film formed using the curable resin composition, a stack including the cured film, an imaging device including the stack, an semiconductor device including the stack, a method for producing the stack, and a method for producing an element including a bonding electrode for use in production of the stack.

### - Solution to problem

The present invention encompasses the following disclosures. The present invention is described in detail below.

### [Disclosure 1]

A curable resin composition containing: an organosilicon compound; and a solvent, the curable resin composition having a viscosity at 25°C of 2,000 cP or less, the solvent being contained in an amount of 50% by weight or less in the curable resin composition, the curable resin composition having an adhesion of a score of 0 to 2 as measured by a cross-cut method in conformity with JIS K5600-5-6 using a measurement sample obtained by spin-coating a silicon wafer with the composition, evaporating the solvent, and then heat curing at 300°C for one hour to form a film.

### [Disclosure 2]

The curable resin composition according to the disclosure 1, wherein a cured product of the curable resin composition obtained by evaporating the solvent and then curing at 300°C for one hour has a tensile modulus of elasticity at 23°C of 100 MPa or greater and 10 GPa or less, and the cured product has a tensile modulus of elasticity at 300°C of 10,000 Pa or greater and 1 GPa or less.

### [Disclosure 3]

The curable resin composition according to the disclosure 1 or 2, wherein a cured product of the curable resin composition obtained by evaporating the solvent and then curing at 300°C for one hour has a weight loss of 6% or less after being heated under a nitrogen atmosphere at 400°C for four hours.

### [Disclosure 4]

The curable resin composition according to any one of the disclosures 1 to 3, wherein the solvent is contained in an amount of 45% by weight or less, and the viscosity at 25°C is 1,500 cP or less.

### [Disclosure 5]

The curable resin composition according to any one of the disclosures 1 to 4, wherein the solvent has a boiling point of 150°C or higher and 250°C or lower.

### [Disclosure 6]

The curable resin composition according to any one of the disclosures 1 to 5, wherein the organosilicon compound has a structure represented by the following formula (1): 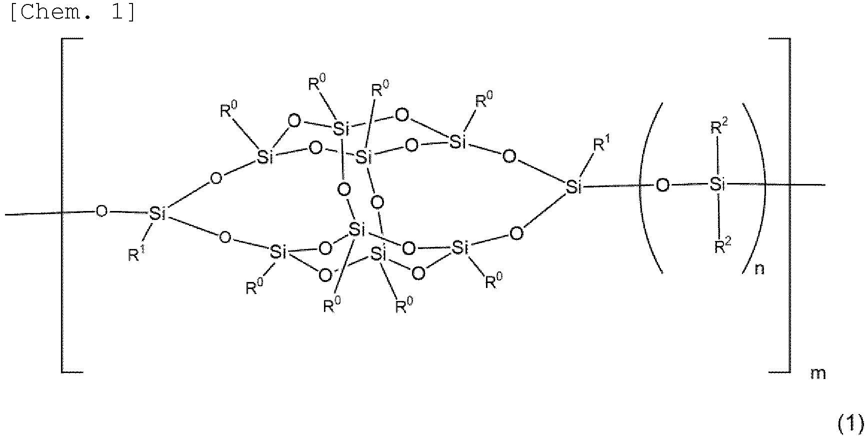 wherein R⁰s, R¹s, and R²s each independently represent a linear, branched, or cyclic aliphatic group, an aromatic group, or hydrogen; the aliphatic group and the aromatic group optionally have a substituent; and m and n each represent an integer of 1 or greater.

### [Disclosure 7]

A curable resin composition containing: an organosilicon compound; and a solvent, the curable resin composition having a viscosity at 25°C of 2,000 cP or less, the solvent being contained in an amount of 50% by weight or less in the curable resin composition, the organosilicon compound having a structure represented by the following formula (1): 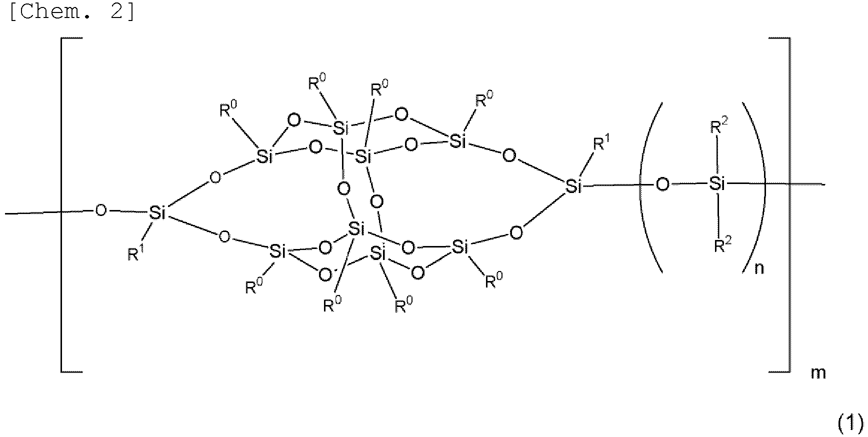 wherein R⁰s, R¹s, and R²s each independently represent a linear, branched, or cyclic aliphatic group, an aromatic group, or hydrogen; the aliphatic group and the aromatic group optionally have a substituent; and m and n each represent an integer of 1 or greater.

### [Disclosure 8]

A cured film formed using the curable resin composition according to any one of the disclosures 1 to 6.

### [Disclosure 9]

The cured film according to the disclosure 8, wherein the cured film has a weight loss of 6% or less after being heated under a nitrogen atmosphere at 400°C for four hours.

### [Disclosure 10]

A stack including: a first element including an electrode; a second element including an electrode; and the cured film according to the disclosure 8 or 9 between the first element and the second element, the electrode of the first element and the electrode of the second element being electrically connected to each other via a through-hole extending through the cured film.

### [Disclosure 11]

The stack according to the disclosure 10, including an inorganic layer between the first element and the second element.

### [Disclosure 12]

The stack according to the disclosure 10 or 11, including a barrier metal layer on a surface of the through-hole.

### [Disclosure 13]

An imaging device including the stack according to any one of the disclosures 10 to 12.

### [Disclosure 14]

A semiconductor device including the stack according to any one of the disclosures 10 to 12.

### [Disclosure 15]

A method for producing a stack, including the steps of: forming cured films by forming a film of the curable resin composition according to any one of claims 1 to 6 on a surface of a first element including an electrode, the surface being a surface on which the electrode is formed, and a film of the curable resin composition on a surface of a second element including an electrode, the surface being a surface on which the electrode is formed, evaporating the solvent, and then curing the films; forming a through-hole in each of the cured films; filling each of the through-holes with a conductive material; forming bonding electrodes by polishing the surface of the first element on the side where the through-hole is filled with the conductive material and the surface of the second element on the side where the through-hole is filled with the conductive material; and bonding the first element on which the bonding electrode is formed and the second element on which the bonding electrode is formed such that the bonding electrodes are bonded to each other.

### [Disclosure 16]

A method for producing an element including a bonding electrode, including the steps of: forming a cured film by forming a film of the curable resin composition according to any one of the disclosures 1 to 6 on a surface of an element including an electrode, the surface being a surface on which the electrode is formed, evaporating the solvent, and then curing the film; forming a through-hole in the cured film; filling the through-hole with a conductive material; and forming a bonding electrode by polishing the surface of the element.

### [Disclosure 17]

A stack including: a supporting substrate; a third element; and the cured film according to the disclosure 8 or 9 between the supporting substrate and the third element, the third element having a first surface and a second surface and including a plurality of chips stacked on the first surface, the chips being electrically connected to the third element; the cured film being provided between the first surface and the supporting substrate.

### [Disclosure 18]

The stack according to the disclosure 17, including an inorganic layer between the supporting substrate and the cured film.

### [Disclosure 19]

The stack according to the disclosure 17 or 18, further including a fourth element on the second surface of the third element, wherein the third element and the fourth element are electrically connected to each other.

### [Disclosure 20]

An imaging device including the stack according to any one of the disclosures 17 to 19.

### [Disclosure 21]

A semiconductor device including the stack according to any one of the disclosures 17 to 19.

The present invention is described in detail below.

The curable resin composition of the present invention contains an organosilicon compound.

When an insulating layer is a cured film of the curable resin composition, which is organic matter, the insulating layer can have high flexibility, reducing warping of elements and increasing the electrical connection reliability. Moreover, the use of an organosilicon compound in the curable resin composition allows the insulating layer to have excellent element-planarization properties.

The organosilicon compound preferably contains a silsesquioxane skeleton in a main chain of a silicon polymer. The organosilicon compound more preferably has a structure represented by the following formula (1). When the organosilicon compound has a structure of the formula (1), the heat resistance and the element-planarization properties can be further enhanced, and misalignment and cracking of electrodes can be further reduced, enhancing the electrical connection reliability. In addition, the later-described viscosity and adhesion can be more easily satisfied.

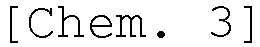

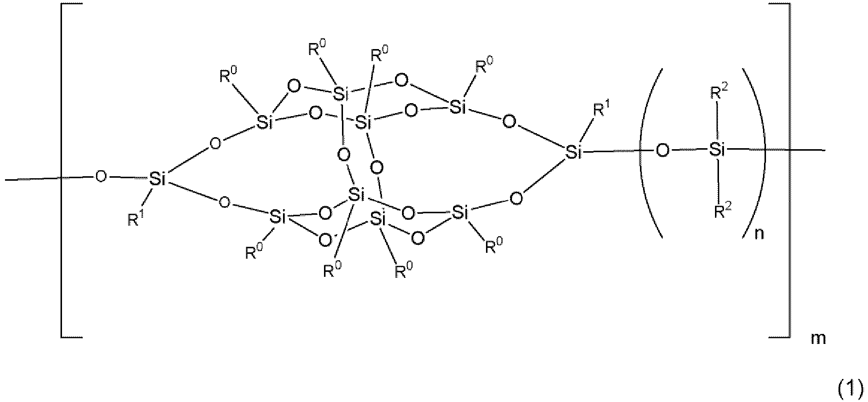

In the formula, R⁰s, R¹s, and R²s each independently represent a linear, branched, or cyclic aliphatic group, an aromatic group, or hydrogen; the aliphatic group and the aromatic group optionally have a substituent; and m and n each represent an integer of 1 or greater.

In the formula (1), R⁰s each independently represent a linear, branched, or cyclic aliphatic group, an aromatic group, or hydrogen; the aliphatic group and the aromatic group optionally have a substituent; and R⁰s are each preferably a phenyl group, a C1-C20 alkyl group, or an arylalkyl group, more preferably a phenyl group. When R⁰s are each a phenyl group, a C1-C20 alkyl group, or an arylalkyl group, the organosilicon compound can have higher heat resistance.

In the formula (1), R¹s and R²s each independently represent a linear, branched, or cyclic aliphatic group, an aromatic group, or hydrogen; the aliphatic group and the aromatic group optionally have a substituent; and R¹s and R²s are each preferably a phenyl group, a C1-C20 alkyl group, or an arylalkyl group, more preferably a phenyl group or a methyl group. When R¹s and R²s are each a phenyl group, a C1-C20 alkyl group, or an arylalkyl group, the organosilicon compound can have higher heat resistance.

In the formula (1), m and n are each an integer of 1 or greater and represent the number of repeating units; m is preferably 30 or greater, more preferably 50 or greater and is preferably 100 or less; and n is preferably 1 or greater, more preferably 3 or greater and is preferably 8 or less, more preferably 6 or less.

The organosilicon compound preferably has a reactive site.

Using a reactive site-containing organosilicon compound as a curable resin of the curable resin composition can further reduce misalignment or cracking of electrodes. Moreover, using a reactive site-containing organosilicon compound can further reduce decomposition of the cured film due to high-temperature treatment performed in the production an electronic component. Examples of the reactive site include a hydroxy group and an alkoxy group. Examples of the reactive site-containing organosilicon compound include organosilicon compounds represented by the formula (1). Although not shown in the structural formula, organosilicon compounds represented by the formula (1) have, at both terminals thereof, reactive functional groups derived from raw materials.

The amount of the organosilicon compound in 100 parts by weight of the amount of solids (amount of components other than the solvent) in the curable resin composition is preferably 80 parts by weight or more, more preferably 90 parts by weight or more, still more preferably 95 parts by weight or more. The amount of the organosilicon compound in 100 parts by weight of the amount of solids in the curable resin composition is preferably less than 100 parts by weight, more preferably 98 parts by weight or less.

The organosilicon compound may have any weight average molecular weight and preferably has a weight average molecular weight of 5,000 or greater and 150,000 or less. When the molecular weight of the organosilicon compound is within the range, the film-forming properties in application can be increased to further enhance the planarization properties. Moreover, misalignment or cracking of electrodes can be further reduced. The molecular weight of the organosilicon compound is more preferably 10,000 or greater, still more preferably 30,000 or greater and is more preferably 100,000 or less, still more preferably 70,000 or less.

The weight average molecular weight of the organosilicon compound is measured by gel permeation chromatography (GPC) as a polystyrene equivalent molecular weight. The weight average molecular weight can be calculated with polystyrene standards using THF as an elution solvent and HR-MB-M 6.0 × 150 mm (available from Waters Corporation) or its equivalent as a column.

The organosilicon compound having a structure of the formula (1) can be obtained by, for example, reacting a compound (2) represented by the following formula (2) with a compound (3) represented by the following formula (3).

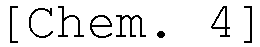

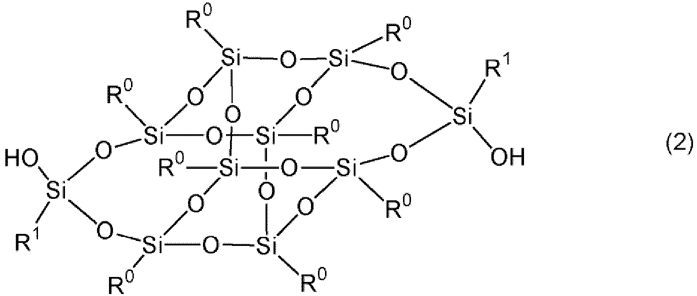

In the formula (2), R⁰s and R¹s represent the same functional groups as R⁰s and R¹s in the formula (1).

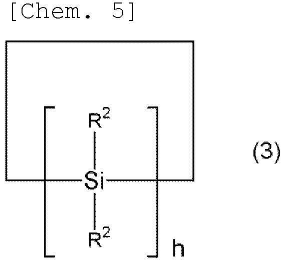

In the formula (3), R²s represent the same functional groups as R²s in the formula (1). In the formula (3), h represents a natural number, preferably 3 to 6, more preferably 3 or 4.

The compound having a structure of the formula (1) can also be obtained by reacting the compound (2) with a halogenated siloxane having R² (e.g., dimethyl siloxane having a chlorinated terminal) instead of the compound (3).

The compound (2) can be obtained by, for example, reacting a salt such as a compound (4) represented by the following formula (4) with a compound (5) represented by the following formula (5). The compound (2) can also be obtained by reacting the compound (5) wherein X is hydrogen with the compound (4) followed by hydrolysis.

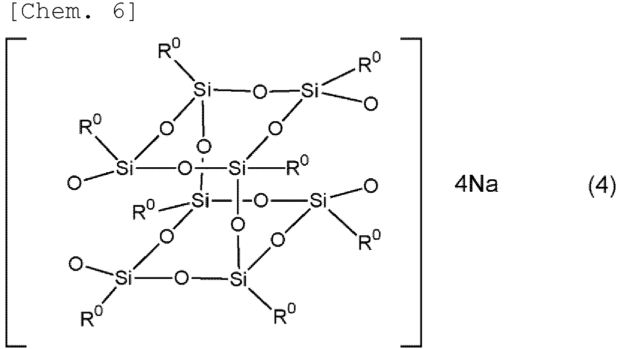

In the formula (4), R⁰s represent the same functional groups as R⁰s in the formula (1).

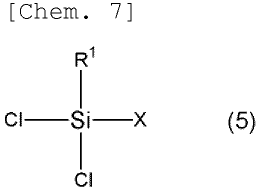

In the formula (5), R¹ represents the same functional group as R¹s in the formula (1); and X represents hydrogen, chlorine, or a hydroxy group.

The compound (4) can be produced by, for example, hydrolysis and polycondensation of a compound (6) represented by the following formula (6) in the presence of a monovalent alkali metal hydroxide and water and in the presence or absence of an organic solvent. The monovalent alkali metal hydroxide used may be lithium hydroxide, sodium hydroxide, potassium hydroxide, cesium hydroxide, or the like.

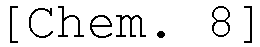

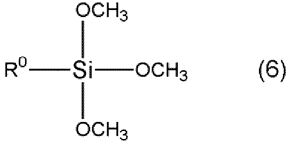

In the formula (6), R⁰ represents the same functional group as R⁰s in the formula (1).

The curable resin composition of the present invention contains a solvent.

When the curable resin composition contains a solvent, the curable resin composition can have a viscosity sufficient for application of the organosilicon compound to an element, while being capable of planarizing an element surface by filling irregularities thereon. As a result, the element bonding reliability can be enhanced, and the electrical connection reliability of the stack can also be improved. The solvent may be composed of a single component or may be a mixture of a plurality of components.

The solvent in the curable resin composition preferably has a boiling point of 150°C or higher and 250°C or lower.

When the boiling point of the solvent is within the range, the planarization properties can be further enhanced. The boiling point of the solvent is more preferably 170°C or higher, still more preferably 180°C or higher and is more preferably 230°C or lower, still more preferably 220°C or lower. Examples of solvents having a boiling point within the range include aromatic organic solvents, lactam organic solvents, and lactone organic solvents. A lactam organic solvent is an organic solvent of a heterocyclic compound having -C(=O)NR- in the ring. A lactone compound is an organic solvent of a heterocyclic compound having - C(=O)- in the ring. Here, R represents a hydrocarbon. Examples of specific compounds include cyclopentanone (boiling point: 131°C), propylene glycol monomethyl ether acetate (boiling point: 146°C), anisole (boiling point: 154°C), ethyl benzoate (boiling point :211°C to 213°C), N-methyl-2-pyrrolidone (boiling point: 202°C), 2-piperidone (boiling point: 256°C), 2-pyrrolidone (boiling point: 245°C), γ-butyrolactone (boiling point: 204°C), and γ-valerolactone (boiling point: 207°C).

The solvent is contained in an amount of 50% by weight or less in the curable resin composition.

When the amount of the solvent in the curable resin composition is within the range, shrinking due to vaporization of the solvent in curing is small, so that the resulting cured film is less likely to have irregularities, providing a planar bonding surface. As a result, the element bonding reliability can be enhanced, and the electrical connection reliability can also be enhanced. The amount of the solvent is preferably 45% by weight or less, more preferably 40% by weight or less, still more preferably 35% by weight or less. The lower limit of the amount of the solvent is not limited but is preferably 30% by weight or more to make it easy to satisfy the later-described viscosity and further enhance the planarization properties.

The amount of the solvent is preferably 50 parts by weight or more and 100 parts by weight or less relative to 100 parts by weight of the organosilicon compound.

When the amount of the solvent relative to the amount of the organosilicon compound is within the range, the later-described viscosity can be easily satisfied, and the element surface-planarizing properties can be further enhanced. The amount of the solvent relative to the organosilicon compound is more preferably 55 parts by weight or more, still more preferably 60 parts by weight or more and is more preferably 80 parts by weight or less, still more preferably 70 parts by weight or less.

The curable resin composition of the present invention preferably contains a catalyst that promotes curing reaction.

When the curable resin composition contains a catalyst, the curable resin composition can be more completely cured, which can further reduce the decomposition of the cured film due to high-temperature treatment.

Examples of the catalyst include: organotin compounds such as dibutyltin dilaurate and tin(II) acetate; metal carboxylates such as zinc naphthenate; zirconia compounds such as zirconium tetraacetylacetonate; and titanium compounds. Preferred among these are zirconium tetraacetylacetonate and dibutyltin dilaurate because they can further promote curing of the curable resin composition.

The catalyst remains after the curable resin composition is cured. In other words, the cured film obtained by curing the curable resin composition of the present invention preferably contains a catalyst that promotes curing reaction.

The amount of the catalyst is not limited and is preferably 0.01 parts by weight or more and 10 parts by weight or less relative to 100 parts by weight of the organosilicon compound in the curable resin composition. When the amount of the catalyst is within the range, curing of the curable resin composition can be further promoted. The amount of the catalyst is more preferably 0.1 parts by weight or more, still more preferably 0.2 part by weight or more and is more preferably 7 parts by weight or less, still more preferably 5 parts by weight or less.

The curable resin composition preferably contains a polyfunctional crosslinking agent capable of reacting with a reactive site of the reactive site-containing organosilicon compound.

Crosslinking between the polymer chains of the reactive site-containing organosilicon compound by a polyfunctional crosslinking agent capable of reacting with a reactive site of the organosilicon compound increases the crosslinking density of the cured product, thus further reducing decomposition at high temperature. As a result, the generation of voids due to the generation of decomposed gas during high-temperature treatment, as well as the resulting misalignment of electrodes in bonding and reduction in electrical connection reliability, can be further prevented. Examples of the polyfunctional crosslinking agent in the case where the reactive site is a silanol group include alkoxysilane compounds such as dimethoxysilane compounds, trimethoxysilane compounds, diethoxysilane compounds, and triethoxysilane compounds and silicate oligomers obtained by condensation of a tetramethoxysilane compound and a tetraethoxysilane compound. In particular, for improvement in the crosslinking density and heat resistance, silicate oligomers are preferred. Examples of alkoxysilane compounds include dimethoxydimethylsilane, trimethoxymethylsilane, tetraethoxysilane, tetrapropoxysilane, and tetrabutoxysilane. Examples of silicate oligomers include Silicate MS51, Silicate MS56, Silicate MS57, and Silicate MS56S (all available from Mitsubishi Chemical Corporation) and Ethyl Silicate 40, Ethyl Silicate 48, and EMS 485 (all available from Colcoat Co., Ltd.).

The amount of the polyfunctional crosslinking agent is not limited but is preferably 1 part by weight or more and 50 parts by weight or less relative to 100 parts by weight of the curable resin in the curable resin composition. When the amount of the polyfunctional crosslinking agent is within the range, the cured film can have a crosslinking density within a suitable range and also can have a hardness within the above-described range after heat treatment. The amount of the polyfunctional crosslinking agent is more preferably 3 parts by weight or more, still more preferably 3.2 parts by weight or more and is more preferably 30 parts by weight or less, still more preferably 20 parts by weight or less.

The curable resin composition preferably contains an adhesion-imparting agent.

When the curable resin composition contains the adhesion-imparting agent, adhesion to silicon wafers can be increased. Examples of the adhesion-imparting agent include silane coupling agents and tackifiers. From the standpoint of the reactivity with a Si element and its associated effect of improving the adhesion to silicon wafers, silane coupling agents are preferred. Examples of the adhesion-imparting agent include KBM-573 (available from Shin-Etsu Chemical Co., Ltd.).

The curable resin composition preferably contains a heat resistant resin.

When a heat resistant resin is used in the curable resin composition, even a thick cured film of the composition is less likely to crack in high-temperature treatment.

Examples of the heat resistant resin include polyimides, epoxy resins, silicone resins, benzoxazine resins, cyanate resins, and phenolic resins. From the standpoint of heat resistance, polyimides are particularly preferred.

The heat resistant resin may have any weight average molecular weight and preferably has a weight average molecular weight of 5,000 or greater and 150,000 or less. When the weight average molecular weight of the heat resistant resin is within the range, the viscosity and solid concentration of the curable resin composition can easily be adjusted to the ranges of the present invention. The molecular weight of the heat resistant resin is more preferably 10,000 or greater, still more preferably 30,000 or greater and is more preferably 100,000 or less, still more preferably 70,000 or less.

The amount of the heat resistant resin is preferably 0.5 parts by weight or more and 50 parts by weight or less relative to 100 parts by weight of the organosilicon compound.

When the amount of the heat resistant resin is within the range, even a thick cured film of the composition is less likely to crack in high-temperature treatment. The amount of the heat resistant resin is more preferably 0.7 parts by weight or more, still more preferably 0.75 parts by weight or more, particularly preferably 1 part by weight or more and is more preferably 20 parts by weight or less, still more preferably 10 parts by weight or less, particularly preferably 5 parts by weight or less, relative to 100 parts by weight of the organosilicon compound.

When the heat resistant resin is a polyimide, the polyimide preferably has a siloxane bond.

When the polyimide has a siloxane bond, the compatibility of the polyimide with the organosilicon compound contained in the curable resin composition is enhanced, so that irregularities (surface roughening) due to precipitation of the polyimide in application can be further reduced.

When the polyimide has a siloxane bond, the polyimide preferably has a ratio of carbon atoms to silicon atoms, C/Si, of 17 or less in the main chain structure.

When the ratio of carbon atoms to silicon atoms in the main chain of the polyimide is within the range, the compatibility of the polyimide with the organosilicon compound contained in the curable resin composition is further enhanced, so that surface roughening in application can be further reduced. The C/Si is more preferably 16.5 or less, still more preferably 16 or less. The lower limit of the C/Si is not limited, but is preferably 4 or greater, from the standpoint of practical use and further enhancing the heat resistance at 400°C. Here, the ratio of carbon atoms to silicon atoms, C/Si, in the main chain structure of the polyimide is the ratio of C to Si in the repeating units and excludes C and Si at both terminals. The C/Si can be determined by obtaining the structure of the polyimide by ¹H-NMR, ¹³C-NMR, and ²⁹Si-NMR and measuring the number of C atoms and Si atoms from the repeating units of the main chain.

The polyimide preferably has an oxazine ring or imide ring structure at at least one terminal, more preferably both terminals.

The polyimide having an oxazine ring or imide ring structure at a terminal can further reduce surface roughening when a thick film is formed. The oxazine ring structure and the imide ring structure may have a substituent.

The polyimide still more preferably has a structure of any of the formulas (7) to (12) at at least one terminal, particularly preferably both terminals. Here, "*" in the formulas represents a linking site to a portion other than the terminal of the polyimide.

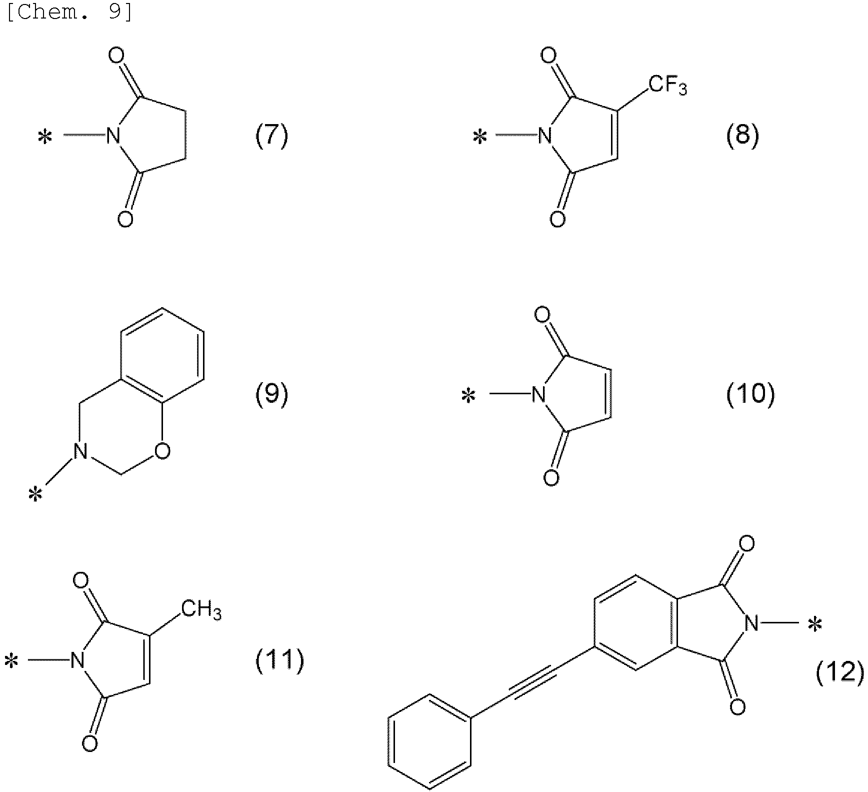

The polyimide preferably has a weight average molecular weight of 1,000 or greater and 50,000 or less.

When the weight average molecular weight of the polyimide is within the range, the compatibility of the polyimide with the organosilicon compound can be improved, leading to higher handleability. The weight average molecular weight is more preferably 2,000 or greater, still more preferably 3,000 or greater and is more preferably 35,000 or less, still more preferably 30,000 or less.

The weight average molecular weight of the polyimide is measured by gel permeation chromatography (GPC) as a polystyrene equivalent molecular weight. The weight average molecular weight can be calculated with polystyrene standards using THF as an elution solvent and HR-MB-M 6.0 × 150 mm (available from Waters Corporation) or its equivalent as a column.

The amount of the polyimide is preferably 0.5 parts by weight or more and 50 parts by weight or less relative to 100 parts by weight of the organosilicon compound.

When the amount of the polyimide is within the range, even a thick cured film of the composition is less likely to crack in high-temperature treatment. The amount of the polyimide is preferably 0.7 parts by weight or more, more preferably 0.75 parts by weight or more, still more preferably 1 part by weight or more and is preferably 20 parts by weight or less, more preferably 10 parts by weight or less, still more preferably 5 parts by weight or less, relative to 100 parts by weight of the organosilicon compound.

The curable resin composition may contain other additives such as viscosity modifiers or fillers, as necessary.

The curable resin composition of the present invention has a viscosity at 25°C of 2,000 cP (2.0 kg/m·s) or less.

When the viscosity of the curable resin composition is within the range, the curable resin composition can planarize even a bonding surface of an element having irregularities by filling the irregularities. This can enhance the element bonding reliability and thus improve the electrical connection reliability. The viscosity at 25°C is preferably 1,500 cP (1.5 kg/m·s) or less, more preferably 1,300 cP (1.3 kg/m·s) or less, still more preferably 1,000 cP (1.0 kg/m·s) or less. The lower limit of the viscosity at 25°C is not limited. From the standpoint of applicability, the lower limit is preferably 10 cP (10 kg/m·s) or greater. The viscosity at 25°C can be adjusted by adjusting the amounts of solid components and/or the amount of the solvent in the curable resin composition.

The viscosity at 25°C can be measured by measuring the kinematic viscosity at 25°C with 10.0 rpm shear using an E-type viscometer (TVE25H, available from Toki Sangyo Co., Ltd., or its equivalent product).

The curable resin composition of the present invention has an adhesion of a score of 0 to 2 as measured by a cross-cut method in conformity with JIS K5600-5-6 using a measurement sample obtained by spin-coating a silicon wafer with the composition, evaporating the solvent, and then heat curing to form a film.

When the cured product of the curable resin composition has an adhesion within the range, the element bonding reliability can be enhanced, and warping of elements or cracking of electrodes can be reduced, so that the electrical connection reliability can be enhanced. The adhesion based on the cross-cut method is preferably 0 to 1, more preferably 0. The adhesion based on the cross-cut method can be adjusted by adjusting factors such as the chemical structure of the organosilicon compound, the structure of a functional group for substitution, the molecular weight, or the presence or absence of the adhesion-imparting agent. Especially when the organosilicon compound has a structure of the formula (1), the adhesion can be suitably increased. More specifically, the adhesion of the cured film can be increased by adjusting m and n in the formula (1) to the above suitable ranges.

Specifically, the adhesion can be measured by the following method.

At room temperature, 12 g of the curable resin composition is dropped onto a center portion of an 8-inch silicon wafer and applied to the silicon wafer (surface roughness <0.1 µm) using a spin coater (ACT-400II, available from Active, Ltd., or its equivalent product). The temperature of the wafer coated with the curable resin is raised from room temperature to 200°C over 30 minutes, followed by drying at 200°C for 90 minutes. The rotation time of the spin coating is adjusted such that the thickness of the curable resin composition after drying will be 25 µm. The wafer is further heated at 300°C for one hour to produce a silicon wafer stack to which the curable resin composition has been applied and cured. Ten cuts are made in the resin surface of the obtained silicon wafer stack at intervals of 1 mm using Super Cutter Guide (available from Taiyu Kizai K.K., or its equivalent product) with a new single-blade cutter. The blade is replaced, and then ten cuts are made again with the cutting direction changed by 90°, thereby forming a 1-mm square grid pattern. A piece of Cellotape^{®} (CT1835, available from Nichiban Co., Ltd., or its equivalent product) is attached to cover the entire grid pattern of the cuts, and rubbed firmly such that air bubbles can be removed and the coating surface can be seen through the tape. The tape is then left to stand at normal temperature for five minutes. The tape is then peeled off at a peel angle of 60° at a rate of 0.3 m/min, and the peel surface was observed. From the state of the peel surface observed, the test results are classified based on JIS K5600-5-6, and the adhesion is classified into scores of 0 to 5.

In the present invention, the adhesion is classified into scores of 0 to 5 as follows.
0: No peeling at any square.
1: In the grid pattern on the measurement sample, the number of "squares that have not completely peeled off but partially peeled off along grid lines" is 1 to 4.
2: In the grid pattern on the measurement sample, the number of "squares have not completely peeled off but partially peeled off along grid lines" is 5 to 11.
3: In the grid pattern on the measurement sample, the number of "squares have not completely peeled off but partially peeled off along grid lines" is 12 to 28, or there is a square that has completely peeled off.
4: In the grid pattern on the measurement sample, the number of "squares have not completely peeled off but partially peeled off along grid lines" is 12 to 28, and there is a square that has completely peeled off.
5: The peel percentage in the grid pattern on the measurement sample is 35% or higher.

The number of squares in which peeling has occurred can be determined by observing peel portions with an optical microscope (available from Olympus Corporation, for example) and calculating the number of squares in which peeling has occurred.

Preferably, a cured product of the curable resin composition of the present invention obtained by evaporating the solvent and then curing at 300°C for one hour has a tensile modulus of elasticity at 23°C of 100 MPa or greater and 10 GPa or less and a tensile modulus of elasticity at 300°C of 10,000 Pa or greater and 1 GPa or less. When the tensile moduli of elasticity at 23°C and 300°C of the curable resin composition are within the ranges, the adhesion can be further enhanced, and the element bonding reliability can be enhanced. As a result, cracking of electrodes can be reduced, so that the electrical connection reliability can be enhanced. The tensile modulus of elasticity at 23°C is more preferably 300 MPa or greater, still more preferably 500 MPa or greater and is more preferably 5 GPa or less, still more preferably 2 GPa or less. The tensile modulus of elasticity at 300°C is more preferably 50,000 Pa or greater, still more preferably 0.1 MPa or greater and is more preferably 500 MPa or less, still more preferably 10 MPa or less.

Here, the tensile modulus of elasticity can be measured using a dynamic viscoelastic analyzer (e.g., DVA-200 available from IT Measurement Co., Ltd.). More specifically, the curable resin composition is applied in a sheet shape using an applicator (Baker applicator SA-201, available from Tester Sangyo Co., Ltd., or its equivalent product), and the temperature of the composition is raised from room temperature to 200°C over 30 minutes, followed by drying at 200°C for 90 minutes. The composition is further heated at 300°C for one hour. Thus, a 500-µm-thick film of a cured product of the curable resin composition is obtained. From the obtained film sample, a measurement sample with a size of 5 mm × 35 mm is punched out. The measurement sample is subjected to measurement under the conditions of a constant-rate temperature rise tensile mode, a rate of temperature rise of 10°C/min, and a frequency of 10 Hz.

Preferably, a cured product of the curable resin composition of the present invention obtained by evaporating the solvent and then curing at 300°C for one hour has a weight loss of 6% or less after nitrogen heating at 400°C for four hours.

When the weight loss of the cured product after nitrogen heating is within the range, elements can be more securely bonded. Moreover, generation of air bubbles or cracks at the interface or delamination at the interface that are caused by decomposition of the cured product in electrode bonding can be further reduced. The weight loss is more preferably 4% or less, still more preferably 3% or less. The lower limit of the weight loss is not limited. The closer to 0%, the better, but the limit is about 0.5%, based on manufacturing techniques. The curing conditions for the curable resin composition are the same as those for the measurement of the tensile modulus of elasticity.

The weight loss after heat treatment at 400°C for four hours can be adjusted by adjusting factors such as the formulation of the curable resin composition, the type of the resin material constituting the curable resin composition, or the curing conditions for the curable resin composition.

Specifically, for example, using a highly heat resistant resin material or an inorganic component or increasing the amount of a crosslinking agent can reduce the weight loss after nitrogen heating at 400°C for four hours.

As for the type of the resin material constituting the cured film, using a highly heat resistant resin (e.g., resin having high molecular weight, or resin having a highly heat resistant main chain or substituent) can reduce the weight loss after nitrogen heating at 400°C for four hours.

Specifically, the weight loss after nitrogen heating at 400°C for four hours can be measured by the following method.

The curable resin composition is applied in a sheet shape using an applicator or the like, and the temperature of the composition is raised from room temperature to 200°C over 30 minutes, followed by drying at 200°C for 90 minutes. The composition is further heated at 300°C for one hour. Thus, a 100-pm-thick film of a cured product of the curable resin composition is obtained. About 3 to 10 mg of the obtained film is weighed, and heated using a thermogravimetry-differential thermal analyzer (TG-DTA: STA7200, available from Hitachi High-Tech Science Corporation, or its equivalent product) under a nitrogen flow (50 mL/min) from 25°C to 400°C at a rate of temperature rise of 10°C/min. After the temperature rise, the weight loss when the film is held at 400°C for four hours is measured.

The method for producing the curable resin composition of the present invention is not limited. For example, it can be produced by mixing the solvent with the organosilicon compound and optional additives such as the catalyst and the polyfunctional crosslinking agent.

The curable resin composition of the present invention contains the organosilicon compound and the solvent and satisfies the viscosity at 25°C, the amount of the solvent, and the adhesion based on the cross-cut method. Thus, the curable resin composition of the present invention can planarize bonding surfaces and connect elements without leaving surface voids even when the elements have irregularities on the surface, thus imparting high bonding reliability between the elements. When the organosilicon compound is one represented by the formula (1), the curable resin composition can exhibit the effects of the present invention only by satisfying the viscosity at 25°C and the amount of the solvent.

The present invention also encompasses such a curable resin composition. Specifically, the present invention also encompasses a curable resin composition containing an organosilicon compound and a solvent, the curable resin composition having a viscosity at 25°C of 2,000 cP or less, the solvent being contained in an amount of 50% by weight or less in the curable resin composition, the organosilicon compound having a structure represented by the following formula (1). The organosilicon compound, the solvent, the viscosity at 25°C, and the amount of the solvent are the same as described above.

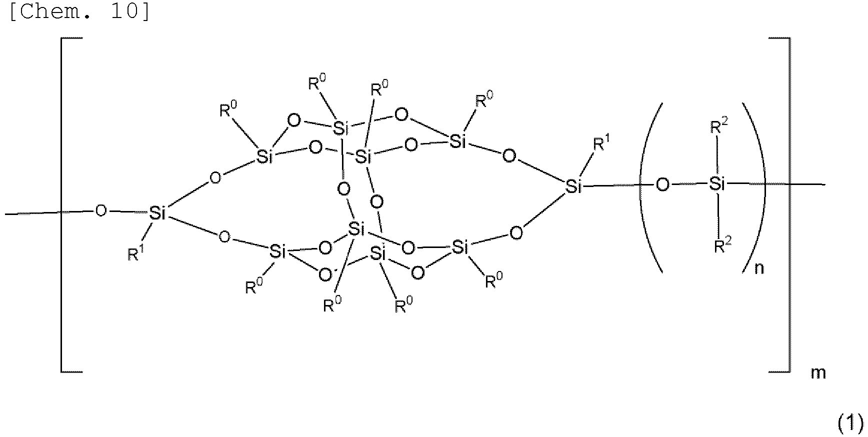

In the formula, R⁰s, R¹s, and R²s each independently represent a linear, branched, or cyclic aliphatic group, an aromatic group, or hydrogen. The aliphatic group and the aromatic group optionally have a substituent; and m and n each represent an integer of 1 or greater.

The curable resin composition of the present invention may be used in any application. Since the curable resin composition has excellent properties of filling and planarizing irregularities, and since the cured film thereof has flexibility, the curable resin composition can be suitably used as an insulating layer in producing a stack by electrically connecting electrodes of two elements including electrodes.

The present invention also encompasses such a cured film formed using the curable resin composition of the present invention.

The cured film of the present invention preferably has a weight loss of 6% or less after nitrogen heating at 400°C for four hours.

When the weight loss of the cured product after nitrone heating at 400°C for four hours is within the range, the elements can be more securely bonded. Moreover, generation of air bubbles or cracks at the interface or delamination at the interface that are caused by decomposition of the cured product in electrode bonding can be further reduced. The weight loss is more preferably 4% or less, still more preferably 30 or less. The lower limit of the weight loss is not limited. The closer to 0%, the better, but the limit is about 0.5%, based on manufacturing techniques.

The weight loss after heat treatment at 400°C for four hours can be adjusted by adjusting factors such as the formulation of the curable resin composition, the type of the resin material constituting the curable resin composition, or the curing conditions for the curable resin composition.

Specifically, for example, using a highly heat resistant resin material or an inorganic component or increasing the amount of a crosslinking agent can reduce the weight loss after nitrogen heating at 400°C for four hours.

As for the type of the resin material constituting the cured film, using a highly heat resistant resin (e.g., resin having high molecular weight, resin having a highly heat resistant main chain or substituent) can reduce the weight loss after at 400°C for four hours. As for the curing conditions for the curable resin composition constituting the cured film, using high temperature that allows curing to sufficiently proceed or prolonging the curing time can reduce the weight loss after nitrogen heating at 400°C for four hours.

Specifically, the weight loss after nitrogen heating at 400°C for four hours can be measured by the following method.

About 3 to 10 mg of the cured film is weighed and heated using a thermogravimetry-differential thermal analyzer (TG-DTA: STA7200, available from Hitachi High-Tech Science Corporation, or its equivalent product) under a nitrogen flow (50 mL/min) from 25°C to 400°C at a rate of temperature rise of 10°C/min. After the temperature rise, the weight loss when the film is held at 400°C for four hours is measured.

The present invention also encompasses a stack including a first element including an electrode, a second element including an electrode, and the cured film of the present invention between the first element and the second element, the electrode of the first element and the electrode of the second element being electrically connected to each other via a through-hole extending through the cured film (hereinafter the stack is also simply referred to as a stack or a stack A). The stack of the present invention is described below.

The stack of the present invention includes a first element including an electrode, a second element including an electrode, and the cured film of the present invention between the first element and the second element, the electrode of the first element and the electrode of the second element being electrically connected to each other via a through-hole extending through the cured film.

The cured film provided between the electrode of the first element (hereinafter also referred to as a first electrode) and the electrode of the second element (hereinafter also referred to as a second electrode) serves as an insulating layer to reduce short-circuit current. Conventional insulating layers contain hard inorganic materials such as Si₃N₄ and SiO₂, and thus cannot eliminate warping by stress relaxation when warping occurs in the formation of an insulating layer or in the formation of a stack. As a result, warping of elements and misalignment or cracking of electrodes due to the warping are likely to occur. In the present invention, the cured film more flexible than an inorganic material film is used as the insulating layer, thus allowing the stack to exhibit high electrical connection reliability. In particular, the resin composition of the present invention, from which the cured film is formed, can fill irregularities and planarize a bonding surface even when an element has irregularities, so that the element bonding reliability can be enhanced, resulting in a stack having high electrical connection reliability. Moreover, conventional insulating layers take time to produce because they are formed by vapor deposition. However, the cured film of the stack of the present invention can be formed by, for example, applying and curing the curable resin composition, thus increasing production efficiency.

The "electrically connected" as used herein means a state in which the first electrode and the second electrode are connected to each other via a conductive material or the like filling the through-hole.

The first element and the second element are not limited and each may be a circuit element provided with an element, a wire, and an electrode. For example, the first element and the second element each may be a sensor circuit element provided with a pixel portion (pixel region) or a circuit element mounted with a peripheral circuit portion such as a logic circuit that implements various types of signal processing related to the operation of a solid-state imaging device, for example.

The materials of the electrodes of the first element and the second element and the conductive material are not limited. Conventional electrode materials such as gold, copper, and aluminum may be used.

The cured film may have any thickness and preferably has a thickness of 10 µm or greater and 300 µm or less.

When the thickness of the cured film is within the range, the cured film can further exhibit the function as an insulating layer while further reducing misalignment or cracking of electrodes. The thickness of the cured film is more preferably 20 µm or greater, still more preferably 30 µm or greater and is more preferably 200 µm or less, still more preferably 100 µm or less.

The stack of the present invention preferably includes an inorganic layer between the first element and the second element.

Providing an inorganic layer between the first element and the second element increases insulation, resulting in a stack having better connection reliability. Conventional stacks include an insulating layer made of an inorganic material having a thickness of about 10 to 20 µm, and thus cannot eliminate warping of the elements and the stack, leading to reduced connection reliability. In the present invention, the insulating layer is the cured film, and thus when the inorganic layer is thin, the stack of the present invention can eliminate warping of the elements and the stack while exhibiting the effect of the inorganic layer.

The material of the inorganic layer is not limited. Examples thereof include Si₃N₄, SiO₂, and Al₂O₃. Preferred among these are Si₃N₄ and SiO₂ because they have excellent insulation and heat resistance.

To further increase the connection reliability of the stack, the inorganic layer preferably has a thickness of 1 nm or greater, more preferably 5 nm or greater, still more preferably 10 nm or greater, while preferably 1 um or less, more preferably 500 nm or less, still more preferably 100 nm or less.

The stack of the present invention preferably includes a barrier metal layer on a surface of the through-hole.

The barrier metal layer serves to prevent the conductive material (e.g., Cu atoms in the case of Cu electrode) filling the through-hole from diffusing into the cured film. The barrier metal layer provided on the surface of the through-hole covers the conductive material filling the through-hole except for the surfaces that contact the electrodes. This can further reduce short circuiting and conduction failure caused by the diffusion of the conductive material into the cured film. The material of the barrier metal layer may be a known material such as tantalum, tantalum nitride, titanium nitride, silicon oxide, or silicon nitride.

The barrier metal layer may have any thickness. To further increase the connection reliability of the stack, the barrier metal layer more preferably has a thickness of 1 nm or greater, still more preferably 10 nm or greater, while more preferably 100 nm or less, still more preferably 50 nm or less.

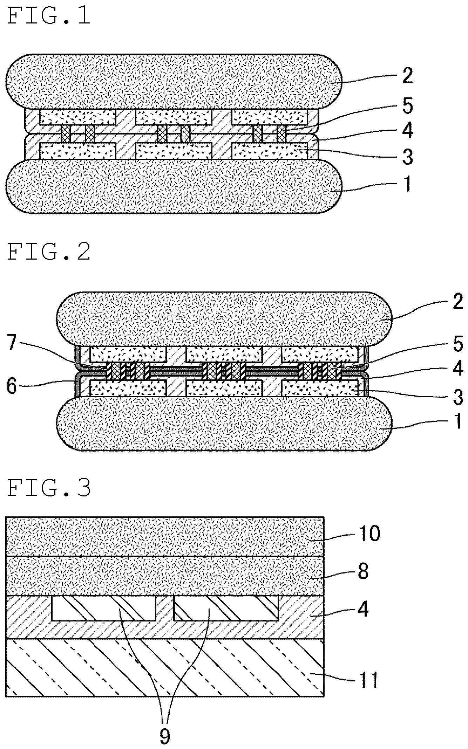

FIG. 1 is a schematic view of an embodiment of the stack of the present invention. As shown in FIG. 1, in the stack of the present invention, a first element 1 including electrodes 3 and a second element 2 including electrodes 3 are bonded to each other through cured films 4. The electrodes 3 on the first element 1 and the electrodes 3 on the second element 2 are electrically connected to each other via a conductive material filling through-holes 5 formed in the cured films 4. Conventional stacks include a hard inorganic material in place of the cured films 4, as an insulating layer. Conventional stacks thus cannot eliminate warping of the elements or the stack by stress relaxation and are more likely to have misalignment or cracking of electrodes. The present invention, which uses a flexible organic compound in the insulating layer, can eliminate warping of the elements and the stack and thus reduce misalignment or cracking of electrodes.

FIG. 2 is a schematic view of an embodiment of the stack of the present invention. In the embodiment in FIG. 2, inorganic layers 6 are formed between the cured films 4, providing higher insulation. The inorganic layers 6 may be far thinner than insulating layers of conventional stacks, and thus do not hinder the elimination of warping of the elements or the stack. Although in FIG. 2 the inorganic layers 6 are formed between the cured films 4, they may be formed on the first element 1 and the second element 2. Although in FIG. 2 the inorganic layers 6 are formed on the respective cured films 4 on the first element 1 side and the second element 2 side, an inorganic layer 6 may be formed on only one of the cured films 4. In the embodiment in FIG. 2, barrier metal layers 7 are formed on the surfaces of the through-holes 5. Forming barrier metal layers 7 on the surfaces of the through-holes 5 makes it difficult for the conductive material filling the through-holes 5 to diffuse into the cured films 4, and thus can further reduce short circuiting and conduction failure.

Examples of the method for producing the stack of the present invention include a method of producing a stack, including the steps of: forming a cured film by forming a film of the curable resin composition of the present invention on a surface of a first element including an electrode, the surface being a surface on which the electrode is formed, evaporating the solvent, and then curing the film; forming a through-hole in the cured film; filling the through-hole with a conductive material; forming a bonding electrode by polishing the surface of the first element on the side where the through-hole is filled with the conductive material; and bonding the first element on which the bonding electrode is formed and a second element on which the bonding electrode is formed such that the bonding electrodes are bonded to each other. The present invention also encompasses such a method for producing a stack.

With the method for producing a stack of the present invention, first, the following step is performed: the step of forming cured films by forming a film of the curable resin composition of the present invention on a surface of a first element including an electrode, the surface being a surface on which the electrode is formed, and a film of the curable resin composition on a surface of a second element including an electrode, the surface being a surface on which the electrode is formed, evaporating the solvent, and then curing the films.

The first element including an electrode, the second element including an electrode, and the curable resin composition may be the same as the first element including an electrode and the second element including an electrode in the stack of the present invention and the curable resin composition of the present invention.

The method for forming the films is not limited. A conventionally known method such as a spin coating method may be used.

The conditions for evaporating the solvent are not limited. To reduce residual solvent and improve the heat resistance of the cured films, heating is preferably performed at a temperature of preferably 70°C or higher, more preferably 100°C or higher and preferably 250°C or lower, more preferably 200°C or lower for, for example, about 30 minutes, more preferably about one hour.

The curing conditions are not limited. To allow the curing reaction to sufficiently proceed and to further improve heat resistance, heating is preferably performed at a temperature of preferably 200°C or higher, more preferably 220°C or higher and preferably 400°C or lower, more preferably 300°C or lower for, for example, about one hour or longer, more preferably about two hours or longer. The upper limit of the heating time is not limited and is preferably three hours or shorter to reduce pyrolysis of the cured films. Specifically, for example, the temperature is raised from room temperature to 200°C over 30 minutes, followed by drying at 200°C for 90 minutes, and then the films are further heated at 300°C for one hour.

With the method for producing a stack of the present invention, subsequently, the step of forming a through-hole in each of the cured films is performed.

The through-hole may be patterned. The method for forming the through-hole is not limited. The through-hole can be formed by laser irradiation such as CO₂ laser irradiation or etching. When a different layer is formed on an electrode surface of an element, the through-hole is formed to extend through the different layer as well as the cured film so that the electrode surface of the element is exposed.

With the method for producing a stack of the present invention, the step of forming an inorganic layer and/or a barrier metal layer is performed, as necessary.

The inorganic layer and the barrier metal layer may be the same as those in the stack of the present invention. The inorganic layer and the barrier metal layer can be formed by sputtering or vapor deposition, for example.

The step of forming an inorganic layer is preferably performed before and/or after the step of forming the cured films. The barrier metal layer is preferably formed after the step of forming a through-hole.

With the method for producing a stack of the present invention, subsequently, the step of filling each of the through-holes with a conductive material is performed. The method of filling the through-holes with the conductive material may be plating, for example.

The conductive material may be the same as the conductive material in the stack of the present invention.

With the method for producing a stack of the present invention, subsequently, the following step is performed: the step of forming bonding electrodes by polishing the surface of the first element on the side where the through-hole is filled with the conductive material and the surface of the second element on the side where the through-hole is filled with the conductive material.

Removing the conductive material on undesired portions by polishing forms a bonding electrode that connects the electrodes formed on the two elements. The polishing preferably planarizes and removes the layer formed of the conductive material until the cured film is exposed or until the inorganic layer, when it is present, is exposed.

The method for polishing is not limited and may be a chemical mechanical polishing method, for example.

The present invention also encompasses a method for producing an element including a bonding electrode, including the steps of: forming a cured film by forming a film of the curable resin composition of the present invention on a surface of an element including an electrode, the surface being a surface on which the electrode is formed, evaporating the solvent, and then curing the film; forming a through-hole in the cured film; filling the through-hole with a conductive material; forming a bonding electrode by polishing the surface of the element.

The element including a bonding electrode is a component used for forming a stack by bonding it to another element including a bonding electrode such that the bonding electrodes between the elements are bonded to each other. The descriptions for the element, the cured film, the curable resin composition, and other structures and the steps are the same as the descriptions for those in the curable resin composition, the stack, and the method for producing a stack of the present invention.

With the method for producing a stack of the present invention, subsequently, the following step is performed: the step of bonding the first element on which the bonding electrode is formed and the second element on which the bonding electrode is formed such that the bonding electrodes are bonded to each other.

The curable resin composition of the present invention can provide cured films with planar bonding surfaces because even when the elements have irregularities on the surface, the composition can fill the irregularities. Such cured films enable secure bonding and can enhance the electrical connection reliability.

The first element and the second element may be bonded by a method of connecting the electrodes and the bonding electrodes by melting them by heat treatment. The heat treatment is typically performed at about 400°C for about four hours.

The stack of the present invention may be used in any application. The stack has high bonding reliability and high electrical connection reliability because of the planarization of the bonding surfaces of the elements, and can particularly reduce warping or cracking of the elements or the stack even when thin elements are bonded to each other. The stack thus can be suitably used as a stack that constitutes a semiconductor device or an imaging device.

The present invention also encompasses such a semiconductor device including the stack of the present invention and such an imaging device including the stack of the present invention.

Examples of a stack including the cured film of the present invention other than the stack A include a stack in which a plurality of chips are stacked on an element, the chips being electrically connected to the element, and the surface of the element on which the chips are stacked is bonded to a supporting substrate via the cured film of the present invention. In a stack with such a structure, the cured film of the present invention does not directly protect the paths of electrical connection because there is no electrical connection between the supporting substrate and the element or between the supporting element and each chip. However, the cured film of the present invention can reduce warping or cracking of the element and the chips by sufficiently filling irregularities thereon, enhancing the connection reliability with the supporting substrate. The cured film thus can enhance the electrical connection reliability between the element and each chip.

The present invention also encompasses such a stack. Specifically, the present invention also encompasses a stack including a supporting substrate, a third element, and the cured film of the present invention between the supporting substrate and the third element, the third element having a first surface and a second surface and including a plurality of chips stacked on the first surface, the chips being electrically connected to the third element, the cured film being provided between the first surface and the supporting substrate (hereinafter the stack is referred to as a stack B).

The stack B of the present invention includes a supporting substrate. Examples of the supporting substrate include glass and monocrystalline silicon.

The stack B of the present invention includes a third element having a first surface and a second surface. The third element includes a plurality of chips stacked on the first surface, the chips being electrically connected to the third element.

The third element may be the same element as the first element and the second element. Examples of the chips include memory circuit elements and logic circuit elements. These chips may be of a single type or may be a combination of chips of different types. The "electrically connected" has the same meaning as in the stack A.

The stack B of the present invention preferably includes an inorganic layer between the supporting substrate and the cured film.

Further providing an inorganic layer between the supporting substrate and the cured film can further enhance insulation. The inorganic layer may be the same as the inorganic layer in the stack A of the present invention.

Preferably, the stack B of the present invention further includes a fourth element on the second surface of the third element, and the third element and the fourth element are electrically connected to each other.

The fourth element may be the same as the first to third elements.

FIG. 3 is a schematic view of an embodiment of the stack B of the present invention. As shown in FIG. 3, the stack B of the present invention includes a plurality of chips 9 stacked on a first surface of a third element 8, the chips being electrically connected to the third element 8. The stack B includes a fourth element 10 stacked on a second surface opposite to the first surface, the fourth element 10 being electrically connected to the third element 8. The first surface of the third element 8 and a supporting substrate 11 are stacked via a cured film 4. Conventional stacks include a hard inorganic material in place of the cured film 4, as an insulating layer. Conventional stacks thus cannot eliminate warping of the elements or the stack by stress relaxation and are more likely to have bonding failure to the supporting substrate due to warping or void formation. The stack B of the present invention can sufficiently fill irregularities between the chips 9 and the supporting substrate 11 and planarize the bonding surface using the cured film of the curable resin composition of the present invention. The stack B thus can eliminate warping and bonding failure of the elements or chips, imparting high electrical connection reliability to the elements.

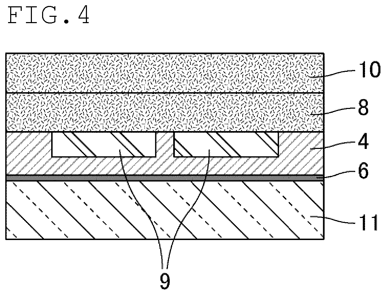

FIG. 4 is a schematic view of an embodiment of the stack of the present invention. The embodiment in FIG. 4 includes, in addition to the components of the embodiment in FIG. 3, an inorganic layer 6 between the cured film 4 and the supporting substrate, providing higher insulation. The inorganic layer 6 may be far thinner than insulating layers of conventional stacks, and thus does not hinder the elimination of warping of the elements or the stack.

Examples of the method for producing the stack B of the present invention include a method of producing a stack, including the steps of: forming a cured film by forming a film of the curable resin composition of the present invention on the first surface of the third element, evaporating the solvent, and then curing the film; and bonding the first surface of the third element, on which the cured film is formed, and the supporting substrate.

With the method for producing the stack B of the present invention, first, the following step is performed: the step of forming a cured film by forming a film of the curable resin composition of the present invention on the first surface of the third element, evaporating the solvent, and then curing the film.

The curable resin composition of the present invention can provide a cured film with a planar bonding surface because even when the element has irregularities on the surface, the composition can fill the irregularities. This enables secure bonding in the later step, so that bonding failure of elements or the stack can be eliminated, imparting high electrical connection reliability between elements. The film formation method and conditions are the same as those for the method for producing the stack A.

With the method for producing the stack B of the present invention, subsequently, the step of forming an inorganic layer is performed, as necessary.

The method for forming the inorganic layer is the same as that for the method for producing the stack A.

With the method for producing the stack B of the present invention, subsequently, the step of bonding the first surface of the third element, on which the cured film is formed, and the supporting substrate is performed.

Examples of the method for bonding the third element and the supporting substrate include a method of chemically bonding the surfaces by heat treatment. The heat treatment is typically performed at about 400°C for about four hours.

The stack B of the present invention may be used in any application. The stack B has high bonding reliability because of the planarization of the boding surface by sufficiently filling irregularities on the element and chips, and can particularly reduce warping or cracking of elements or the stack even when thin elements are bonded to each other. The stack B thus can be suitably used as a stack that constitutes a semiconductor device or an imaging device.

The present invention also encompasses such a semiconductor device including the stack B of the present invention and such an imaging device including the stack of the present invention.

### - Advantageous Effects of Invention

The present invention can provide a curable resin composition that can planarize bonding surfaces and connect elements without leaving surface voids even when the elements have irregularities on the surface, thus imparting high bonding reliability between the elements, a cured film formed using the curable resin composition, a stack including the cured film, an imaging device including the stack, an semiconductor device including the stack, a method for producing the stack, and a method for producing an element including a bonding electrode for use in production of the stack.

### BRIEF DESCRIPTION OF DRAWINGS

FIG. 1 is a schematic view of an embodiment of the stack of the present invention.
FIG. 2 is a schematic view of an embodiment of the stack of the present invention.
FIG. 3 is a schematic view of an embodiment of the stack of the present invention.
FIG. 4 is a schematic view of an embodiment of the stack of the present invention.

### DESCRIPTION OF EMBODIMENTS

Embodiments of the present invention are more specifically described in the following with reference to examples. The present invention, however, is not limited to these examples.

### (1) Production of resin A

A reaction vessel equipped with a reflux condenser, a thermometer, and a dropping funnel was charged with 65.4 g of phenyltrimethoxysilane (available from Tokyo Chemical Industry Co., Ltd., molecular weight 198.29), 8.8 g of sodium hydroxide, 6.6 g of water, and 263 mL of 2-propanol. Heating was started under a nitrogen gas flow with stirring. Stirring was continued for six hours from the start of reflux, and the mixture was then left to stand overnight at room temperature. The reaction mixture was transferred into a filter and filtered by pressurization with nitrogen gas. The obtained solid was washed with 2-propyl alcohol once, filtered, and then dried at 80°C under reduced pressure to give 33.0 g of a colorless solid (DD-ONa).

A three-neck flask equipped with a dropping funnel, a reflux condenser, and a thermometer and having an inner capacity of 300 ml was charged with 11.6 g of a compound (DD-ONa), 100 g of tetrahydrofuran, and 3.0 g of triethylamine, and sealed with dry nitrogen. With stirring using a magnetic stirrer, 4.5 g (30 mmol) of methyltrichlorosilane was added dropwise at room temperature. The mixture was then stirred for three hours at room temperature. To the reaction solution was added 50 g of water to dissolve the produced sodium chloride and hydrolyze unreacted methyltrichlorosilane. The resulting reaction mixture was separated into layers, and the organic layer was washed with 1 N hydrochloric acid once and with a saturated sodium hydrogen carbonate aqueous solution once, and further water-washed with ion-exchanged water three times. The washed organic layer was dried with anhydrous magnesium sulfate and concentrated under reduced pressure using a rotary evaporator, whereby 7.1 g of white powdery solid (DD(Me)-OH) was obtained.

A condenser, a mechanical stirrer, a Dean-Stark trap, an oil bath, and a thermometer protecting tube were attached to a 100-mL flask. The air inside the flask was purged with nitrogen. The flask was charged with 5.0 g of the DD(Me)-OH, 18.1 g of octamethylcyclotetrasiloxane (D4), 5.1 g of sulfuric acid, 59 g of toluene, and 14.5 g of 4-methyltetrahydropyran. After stirring at 100°C for five hours, water was poured to the reaction mixture, and the aqueous layer was extracted with toluene. The combined organic layers were washed with water, a sodium hydrogen carbonate aqueous solution and saturated saline, and then dried with anhydrous sodium sulfate. This solution was concentrated under reduced pressure. The residue was reprecipitated in a solution containing 2-propanol and ethyl acetate at 50:7 (weight ratio) for purification and dried. Thus, an organosilicon compound (resin A, weight average molecular weight 36,000) having the structure of the following formula (13) wherein m2 is 30 and the average of n2 (number of DMS chains) is 4 was obtained.

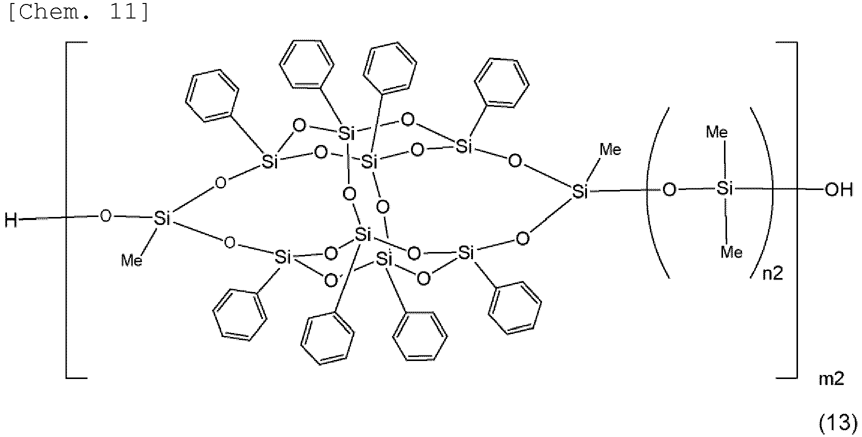

### (2) Production of resin B

A condenser, a mechanical stirrer, a Dean-Stark trap, an oil bath, and a thermometer protecting tube were attached to a 100-mL flask. The air inside the flask was purged with nitrogen. The flask was charged with 5.0 g of the DD(Me)-OH, 11.2 g of octamethylcyclotetrasiloxane (D4), 3.9 g of sulfuric acid, 52.0 g of toluene, and 13.0 g of 4-methyltetrahydropyran. After stirring at 100°C for five hours, water was poured to the reaction mixture, and the aqueous layer was extracted with toluene. The combined organic layers were washed with water, a sodium hydrogen carbonate aqueous solution and saturated saline, and then dried with anhydrous sodium sulfate. This solution was concentrated under reduced pressure. The residue was reprecipitated in a solution containing 2-propanol and ethyl acetate at 50:7 (weight ratio) for purification and dried. Thus, an organosilicon compound (resin B, weight average molecular weight 46,000) having the structure of the formula (13) wherein m2 is 36 and the average of n2 (number of DMS chains) is 3 was obtained.

### (3) Production of resin C

A condenser, a mechanical stirrer, a Dean-Stark trap, an oil bath, and a thermometer protecting tube were attached to a 100-mL flask. The air inside the flask was purged with nitrogen. The flask was charged with 5.0 g of the DD(Me)-OH, 22.9 g of octamethylcyclotetrasiloxane (D4), 2.8 g of sulfuric acid, 60.0 g of toluene, and 15.0 g of 4-methyltetrahydropyran. After stirring at 100°C for six hours, water was poured to the reaction mixture, and the aqueous layer was extracted with toluene. The combined organic layers were washed with water, a sodium hydrogen carbonate aqueous solution and saturated saline, and then dried with anhydrous sodium sulfate. This solution was concentrated under reduced pressure. The residue was reprecipitated in a solution containing 2-propanol and ethyl acetate at 29:2 (weight ratio) for purification and dried. Thus, an organosilicon compound (resin C, weight average molecular weight 52,000) having the structure of the formula (13) wherein m2 is 44 and the average of n2 (number of DMS chains) is 5 was obtained.

### (4) Production of resin D

A reaction vessel equipped with a stirring device, a water separator, a thermometer, and a nitrogen gas introduction device was charged with 11.41 g of 4,4'-(hexafluoroisopropylidene)diphthalic anhydride (available from Tokyo Chemical Industry Co., Ltd., molecular weight 444.24), which is a tetracarboxylic dianhydride, and 92.72 g of anisole. The solution in the reaction vessel was heated to 60°C. Subsequently, 7.573 g of PAM-E (available from Shin-Etsu Chemical Co., Ltd., molecular weight 280.51), which is an aromatic diamine, was added into the reaction vessel. A Dean-Stark trap and a condenser were attached to a flask. The mixture was heated and refluxed at 100°C for one hour and further refluxed at 170°C for four hours, whereby an imide compound having an amine at both terminals was obtained. After cooling, citraconic anhydride (available from Tokyo Chemical Industry Co., Ltd., molecular weight 112.08) was added and stirred with heating at 120°C for 10 minutes, and further heated at 170°C for 20 minutes, whereby a compound (resin D, weight average molecular weight 25,000) having an imide structure of the following formula (14) was obtained. Separately, a resin D having a weight average molecular weight of 69,000 was obtained by the same process with the same amounts of materials added, except that the amount of 4,4'-(hexafluoroisopropylidene)diphthalic anhydride, a tetracarboxylic dianhydride, added was 11.76 g. Additionally, a resin D having a weight average molecular weight of 9,000 was obtained by the same process with the same amounts of materials added, except that the amount of 4,4'-(hexafluoroisopropylidene)diphthalic anhydride, a tetracarboxylic dianhydride, added was 10.00 g.

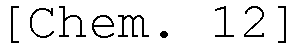

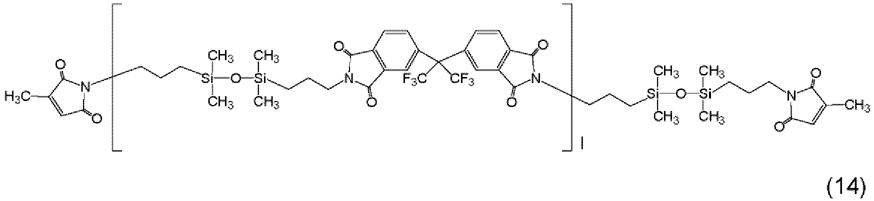

In the formula, l is an integer of 1 or greater and represents the number of repeating units.

### (5) Production of resin E

A reaction vessel equipped with a stirring device, a water separator, a thermometer, and a nitrogen gas introduction device was charged with 120.0 g of 4,4'-(hexafluoroisopropylidene)diphthalic anhydride (available from Tokyo Chemical Industry Co., Ltd., molecular weight 444.24), which is a tetracarboxylic dianhydride, and 400 g of toluene. The solution in the reaction vessel was heated to 60°C. Subsequently, 147.11 g of 2,2-bis[4-(4-aminophenoxy)phenyl]hexafluoropropane (available from Tokyo Chemical Industry Co., Ltd., molecular weight 518.46), which is an aromatic diamine, was added into the reaction vessel. A Dean-Stark trap and a condenser were attached to a flask. The mixture was heated and refluxed at 100°C for one hour and further refluxed at 170°C for four hours, whereby an imide compound having an amine at both terminals was obtained. Subsequently, an excess amount of phenol and paraformaldehyde were added to the reaction solution. The obtained mixture was further refluxed at 170°C for one hour to be terminated with benzoxazine. After the completion of the reaction, isopropanol was added for reprecipitation, and the precipitate was recovered and dried. Thus, a benzoxazine structure-containing compound (resin E, weight average molecular weight 35,000) having the structure of the following formula (15) was obtained. The compound had an imide skeleton and had a benzoxazine structure at terminals. Separately, a resin E having a weight average molecular weight of 4,000 was obtained by the same process with the same amounts of materials added, except that the amount of 4,4'-(hexafluoroisopropylidene)diphthalic anhydride, a tetracarboxylic dianhydride, added was 142.76 g.

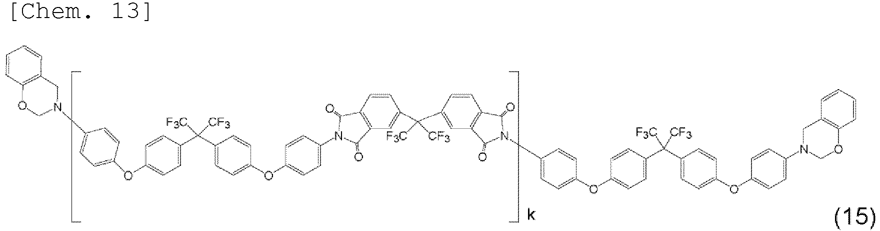

In the formula, k is an integer of 1 or greater and represents the number of repeating units.

### (6) Resin F

SR-3321 available from Konishi Chemical Ind. Co., Ltd. was used. SR-3321 is an organosilicon compound that does not have the structure represented by the following formula (1).

### (7) Production of resin G

A condenser, a mechanical stirrer, a Dean-Stark trap, an oil bath, and a thermometer protecting tube were attached to a 100-mL flask. The air inside the flask was purged with nitrogen. The flask was charged with 5.0 g of the DD(Me)-OH, 11.2 g of octamethylcyclotetrasiloxane (D4), 2.1 g of sulfuric acid, 52.0 g of toluene, and 13.0 g of 4-methyltetrahydropyran. After stirring at 100°C for five hours, water was poured to the reaction mixture, and the aqueous layer was extracted with toluene. The combined organic layers were washed with water, a sodium hydrogen carbonate aqueous solution and saturated saline, and then dried with anhydrous sodium sulfate. The solution was concentrated under reduced pressure. The residue was reprecipitated in a solution containing 2-propanol and ethyl acetate at 50:7 (weight ratio) for purification and dried. Thus, an organosilicon compound (resin G, weight average molecular weight 130,000) having the structure of the formula (13) wherein m2 is 110 and the average of n2 (number of DMS chains) is 3 was obtained.

### (8) Resin H

SST-3PM4 available from Gelest, Inc. was used. SST-3PM4 is an organosilicon compound that does not have the structure represented by the following formula (1).

### (9) Resin I

### (Production method and structure)

A condenser, a mechanical stirrer, a Dean-Stark trap, an oil bath, and a thermometer protecting tube were attached to a 100-mL flask. The flask was charged with 3.9 g of bisaminopropyltetramethyldisiloxane (PAM-E, available from Shin-Etsu SiliconeCo., Ltd.), 36.3 g of anisole, 3.53 g of maleic anhydride (available from Tokyo Chemical Industry Co., Ltd.), and they were stirred. The mixture was refluxed in an oil bath at 170°C for two hours. The obtained synthesis solution was cooled to room temperature and then passed through a membrane filter (product number: ADVANTEC T080A075C, available from Toyo Roshi Kaisha, Ltd.). Thus, an additive B having the structure of the following formula (16) was obtained as a precipitate.

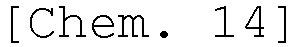

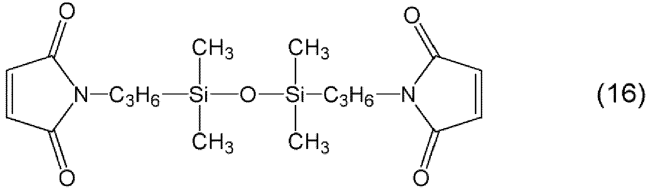

### (10) Production of resin J

A reaction vessel equipped with a stirring device, a water separator, a thermometer, and a nitrogen gas introduction device was charged with 13.532 g of 4,4'-(4,4'-isopropylidenediphenoxy)diphthalic anhydride (BPADA, available from Tokyo Chemical Industry Co., Ltd., molecular weight 520.49), which is a tetracarboxylic dianhydride, and 103.05 g of anisole. The solution in the reaction vessel was heated to 60°C. Subsequently, 7.573 g of PAM-E (available from Shin-Etsu Chemical Co., Ltd., molecular weight 280.51), which is an aromatic diamine, was added into the reaction vessel. A Dean-Stark trap and a condenser were attached to a flask. The mixture was heated and refluxed at 100°C for one hour and further refluxed at 170°C for four hours, whereby an imide compound having an amine at both terminals was obtained. After cooling, citraconic anhydride (available from Tokyo Chemical Industry Co., Ltd., molecular weight 112.08) was added and stirred with heating at 120°C for 10 minutes, and further heated at 170°C for 20 minutes, whereby an imide structurecontaining compound (resin J, weight average molecular weight 35,000) having the structure of the following formula (17) was obtained.

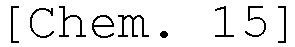

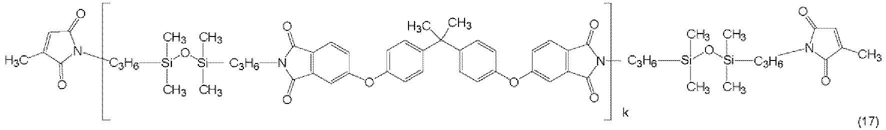

In the formula, k is an integer of 1 or greater and represents the number of repeating units.

### (11) Resin K

Benzoxazine P-d (available from Shikoku Chemicals Corporation) was used.

### (12) Resin L

CYTESTER P-201 (available from Mitsubishi Gas Chemical Company, Inc.) was used.

### (Example 1)

Anisole as a solvent was added to 100 parts by weight of the resin A, 3.2 parts by weight of a crosslinking agent (Silicate MS-51, available from Mitsubishi Chemical Corporation), and 0.2 parts by weight of a catalyst (ZC-162, available from Matsumoto Fine Chemical Co., Ltd.), such that the amount of anisole was 40% by weight. Thus, a curable resin composition was obtained.

### (Examples 2 to 32 and Comparative Examples 1 to 6)

Curable resin compositions were obtained as in Example 1, except that the formulations were as shown in Tables 1 to 3. The materials in the tables that are not described herein are listed below.
BYK-307 (available from BYK)
KBM-573 (available from Shin-Etsu Chemical Co., Ltd.) Dibutyltin dilaurate (available from Tokyo Chemical Industry Co., Ltd.)

### <Physical properties>

The following measurements were performed on the obtained curable resin compositions. Tables 1 to 3 show the results.

### (Viscosity measurement)

The viscosity at 25°C with 10.0 rpm shear was measured using an E-type viscometer (TVE25H, available from Toki Sangyo Co., Ltd.).

### (Adhesion measurement)

At room temperature, 12 g of the curable resin composition was dropped to a center portion of an 8-inch silicon wafer and applied onto the silicon wafer using a spin coater (ACT-400II, available from Active, Ltd.) at a rotation rate of 500 rpm. The temperature of the wafer coated with the curable resin composition was raised from room temperature to 200°C over 30 minutes, followed by drying at 200°C for 90 minutes. At this time, the rotation time of the spin coating was adjusted such that the thickness of the curable resin composition after being dried would be 25 um. The wafer was further heated at 300°C for one hour to produce a silicon wafer stack in which the cured product of the curable resin composition was stacked on the silicon wafer. Ten cuts were made in the resin surface of the obtained silicon wafer stack at intervals of 1 mm using Super Cutter Guide (available from Taiyu Kizai K.K.) with a new single-blade cutter. The blade was replaced, and then ten cuts were made again with the cutting direction changed by 90°, thereby forming a 1-mm square grid pattern. A piece of Cellotape^{®} (CT1835, available from Nichiban Co., Ltd.) was attached to cover the entire grid pattern of the cuts, and rubbed firmly such that air bubbles were removed and the coating surface was seen through the tape. The Cellotape^{®} was then left to stand at normal temperature for five minutes. After standing, the Cellotape^{®} was peeled off at a peel angle of 60° at a rate of 0.3 m/min, and the peel surface was observed. From the state of the observed peel surface, the test results were classified based on JIS K5600-5-6 and classified into scores of 0 to 5, whereby the adhesion based on the cross-cut method was determined. The score classification was based on the evaluation criteria described above.

### (Measurement of tensile modulus of elasticity)

The curable resin composition was applied in a sheet shape using an applicator, and the temperature of the composition was raised from room temperature to 200°C over 30 minutes, followed by drying at 200°C for 90 minutes. The composition was further heated at 300°C for one hour. Thus, a 500-µm-thick film of a cured product of the curable resin composition was obtained. From the obtained film sample, a measurement sample with a size of 5 mm × 35 mm was punched out. The tensile moduli of elasticity of the obtained measurement sample at 23°C and 300°C were measured under the conditions of a constant-rate temperature rise tensile mode, a rate of temperature rise of 10°C/min, and a frequency of 10 Hz using a dynamic viscoelastic analyzer (DVA-200 available from IT Measurement Co., Ltd.). In Examples 9 and 10 and Comparative Examples 1, 2, and 6, the moduli were not able to be measured because the film samples were highly brittle and failed to have the predetermined size.

### (Measurement of weight loss)

The curable resin composition was applied in a sheet shape using an applicator or the like, and the temperature of the composition was raised from room temperature to 200°C over 30 minutes, followed by drying at 200°C for 90 minutes. The composition was further heated at 300°C for one hour. Thus, a 500-µm-thick film of a cured product of the curable resin composition was obtained. The obtained film sample was heated using a thermogravimetry-differential thermal analyzer (TG-DTA: STA7200, available from Hitachi High-Tech Science Corporation) under a nitrogen flow (50 mL/min) from 25°C to 400°C at a rate of temperature rise of 10°C/min. The weight loss after heating under the nitrogen atmosphere at 400°C for four hours was measured.

### (Measurement of 5% weight loss temperature)

The curable resin composition was applied in a sheet shape using an applicator, and the temperature of the composition was raised from room temperature to 200°C over 30 minutes, followed by drying at 200°C for 90 minutes. The composition was further heated at 300°C for one hour. Thus, a 500-µm-thick film of a cured product of the curable resin composition was obtained. The obtained film sample was heated using a thermogravimetry-differential thermal analyzer (TG-DTA: STA7200, available from Hitachi High-Tech Science Corporation) under a nitrogen flow (50 mL/min) from 25°C to 550°C at a rate of temperature rise of 10°C/min. The temperature at which the weight loss of the film sample reached 5% was measured.

### <Evaluation>

The curable resin compositions obtained in the examples and the comparative examples were evaluated as follows. Tables 1 to 3 show the results.

### (Evaluation of film-forming properties)

At room temperature, 12 g of the obtained curable resin composition was dropped onto a center portion of an 8-inch silicon wafer and applied to the silicon wafer (surface roughness <0.1 um) using a spin coater (ACT-400II, available from Active, Ltd., or its equivalent product). The temperature of the coated wafer was raised from room temperature to 200°C over 30 minutes, followed by drying at 200°C for 90 minutes. At this time, the rotation time of the spin coating was adjusted such that the thickness of the curable resin composition after being dried would be 25 um. The wafer was further heated at 300°C for one hour to cure the curable resin composition. After cooling to room temperature, the application side (surface) of the cured product of the curable resin composition was observed and evaluated for the film-forming properties in accordance with the following criteria.
○ (Good): No cracking.
× (Poor): The resin was not distributed over the entire surface of the silicon wafer under the predetermined rotation conditions, or cracking occurred after the solvent was evaporated.

### (Evaluation of planarity)

An amount of 12 g of the obtained curable resin composition was dropped onto a center portion of an 8-inch silicon wafer that had grooves (10 um deep and 300 um wide) at intervals of 40 mm, and applied to the silicon wafer (surface roughness of the portions other than the grooves <0.1 µm) to form a film using a spin coater (ACT-400II, available from Active, Ltd.). The temperature of the coated wafer was raised from room temperature to 200°C over 30 minutes, followed by drying at 200°C for 90 minutes. At this time, the rotation time of the spin coating was adjusted such that the thickness of the curable resin composition after being dried would be 25 um. The wafer was further heated at 300°C for one hour to cure the curable resin composition. The groove portions of the silicon wafer on the surface of the heat-cured product of the curable resin composition was observed using a laser microscope (OLS4100, available from Olympus Corporation), and the depth of the groove portions was measured. The amount of indentation (%) was determined as the percentage (value represented by the formula below) obtained by dividing the depth of the grooves measured with the laser microscope by the original depth (10 um) of the grooves of the wafer. The planarity was evaluated in accordance with the following criteria. In Comparative Examples 4 to 6, the planarity was not able to be measured because the resins did not spread over the entire surface of the wafer due to their low film-forming properties. The numerical values in the parentheses in the tables are the depths (µm) of the grooves after application and curing of the curable resin compositions. Amount of identation (%) = (Depth of grooves after application and curing of curable resin composition (µm))/10 (µm) × 100
oo (Excellent): Indentation of less than 20%
o (Good): Indentation of 20% or more and less than 35%
× (Poor): Indentation of 35% or more

### (Evaluation of heat resistance)

The heat resistance was evaluated in accordance with the following criteria based on the measurement results of the weight loss.
○○ (Excellent): Weight loss of less than 1.5%
○ (Good): Weight loss of 1.5% or more and less than 6%
× (Poor): Weight loss of 6% or more

### (Evaluation of film cracking)

An amount of 12 g of the curable resin composition was ejected onto a center portion of an 8-inch silicon wafer (surface roughness <0.1 µm) and formed into a film on the silicon wafer (surface roughness of the portions other than grooves <0.1 um) using a spin coater (ACT-400II, available from Active, Ltd.). The temperature was raised from room temperature to 200°C over 30 minutes, followed by drying at 200°C for 90 minutes. At this time, the rotation time of the spin coating was adjusted such that the thickness of the curable resin composition after being dried would be 25 um. The wafer was further heated at 300°C for one hour to form a cured film of the curable resin composition. The obtained cured film was heattreated for three hours under a nitrogen atmosphere using Rapid Thermal Vacuum Process Oven (VPO-650, available from UniTemp), and film cracking was evaluated in accordance with the following criteria.
○○ (Excellent): No film cracking occurred even after heat treatment at 400°C for three hours.
○ (Good): No film cracking occurred after heat treatment at 380°C for three hours, but film cracking occurred after heat treatment at 400°C for three hours.
× (Poor): Film cracking occurred after heat treatment at 380°C for three hours.

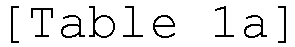

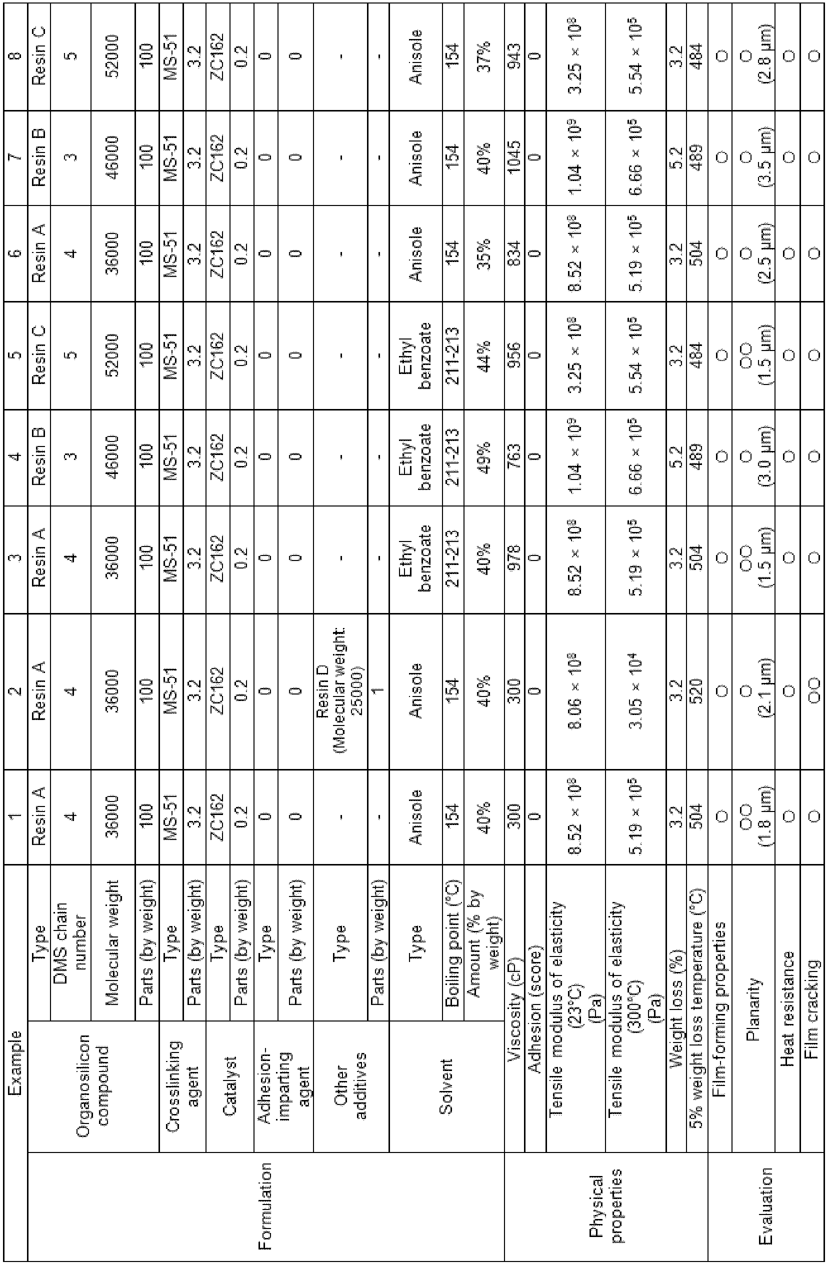

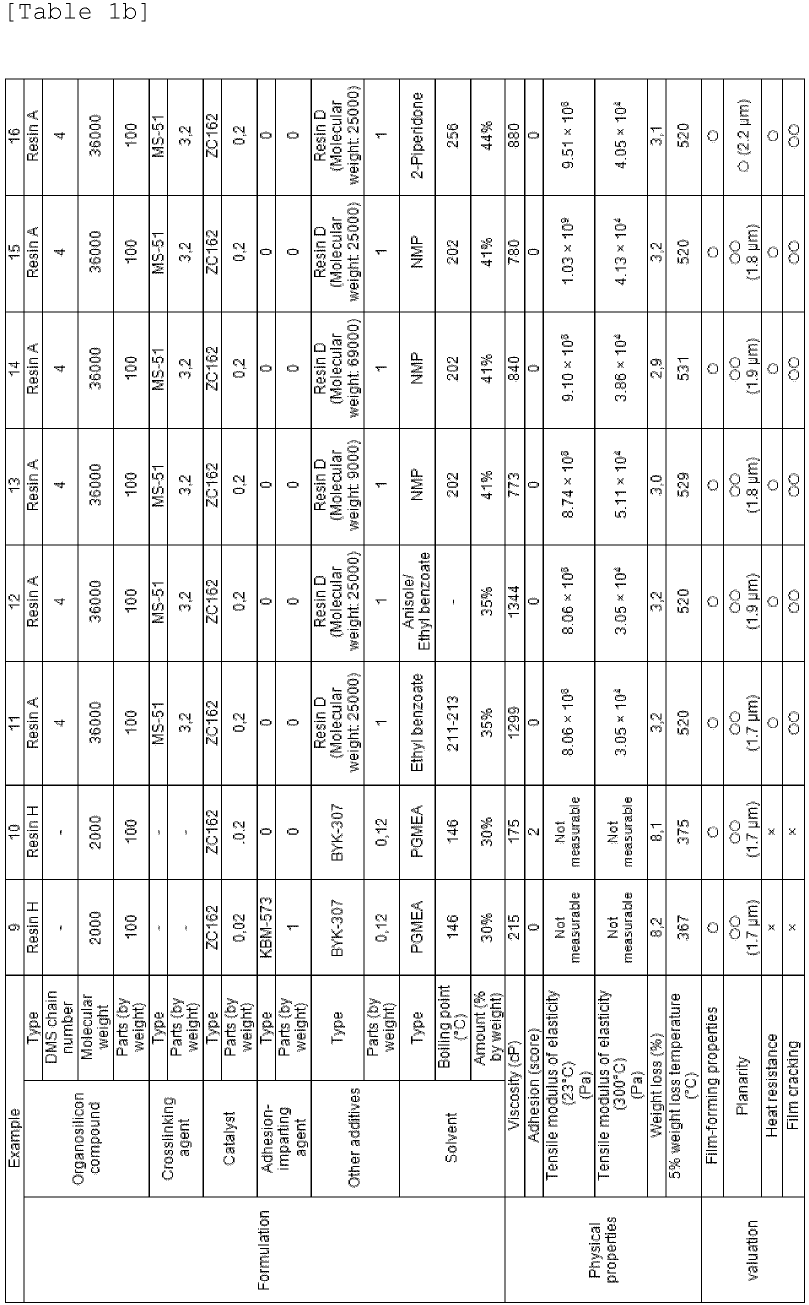

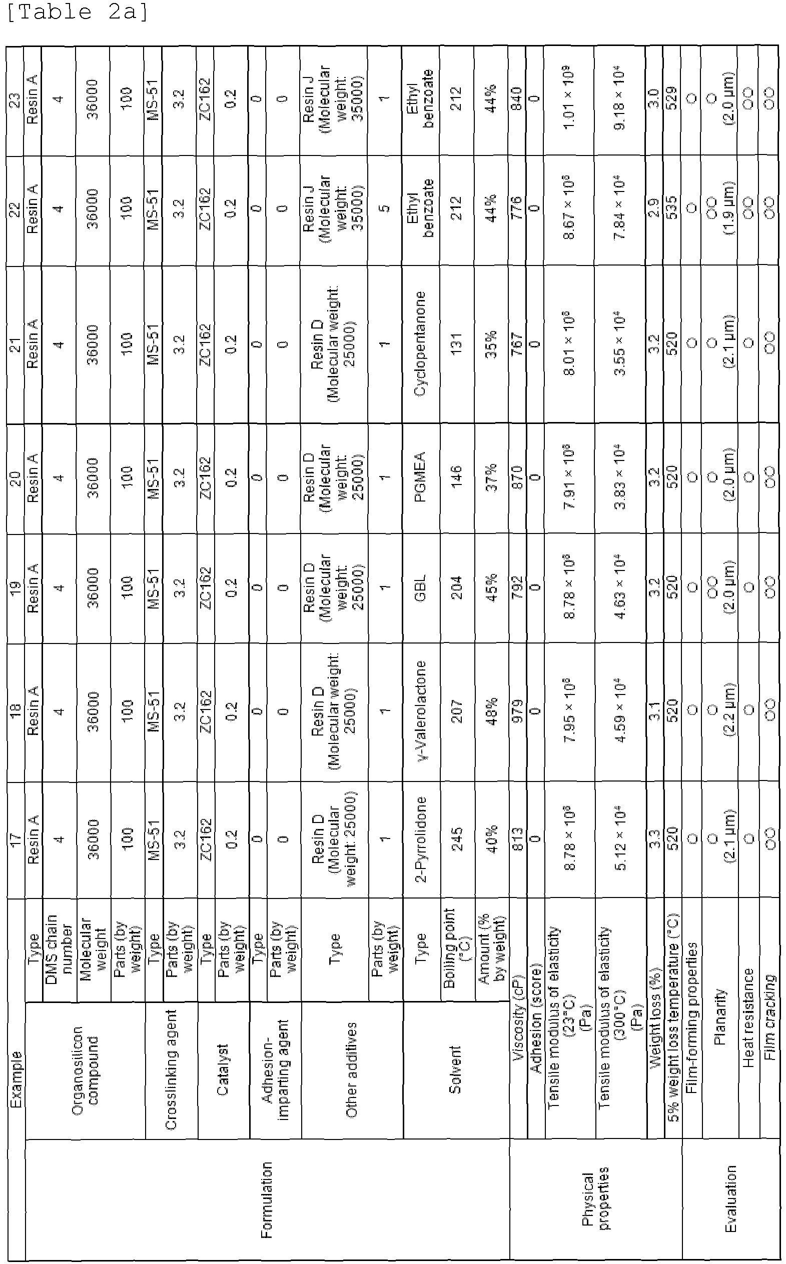

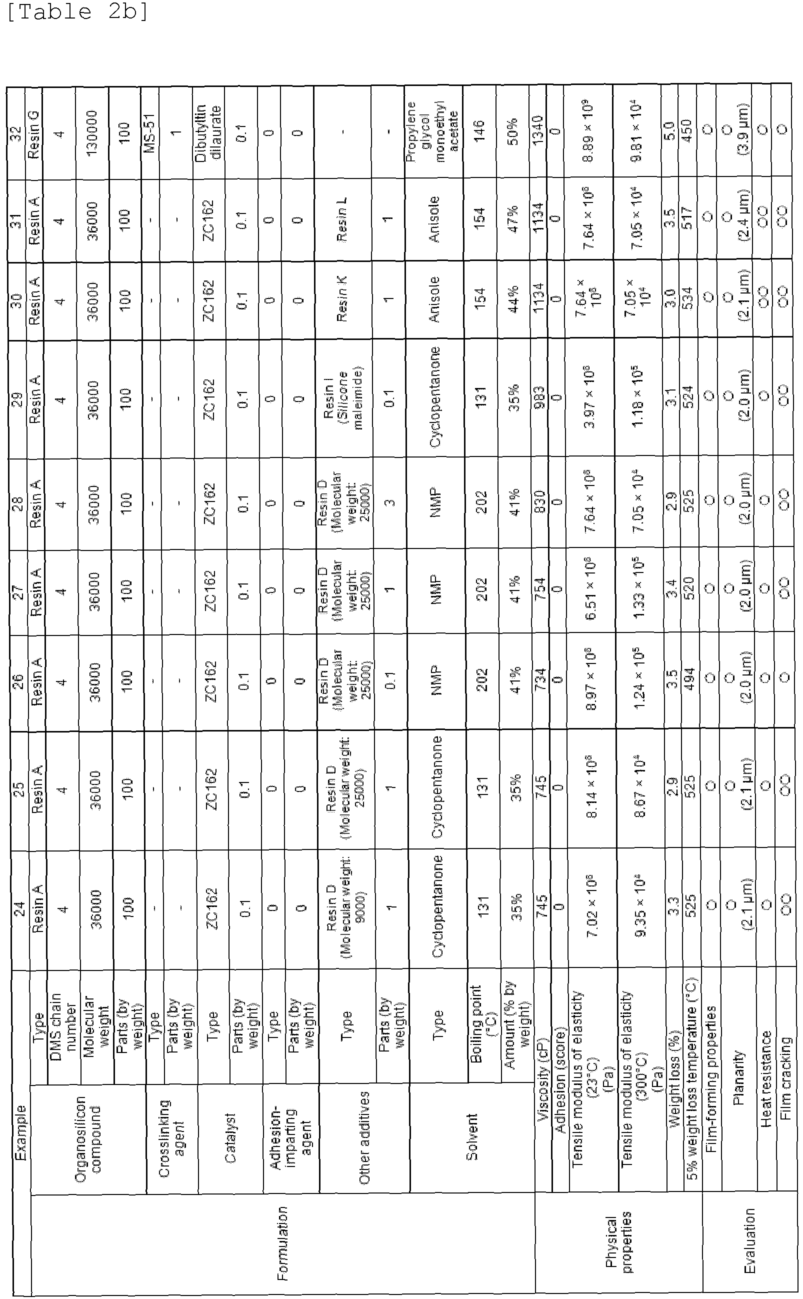

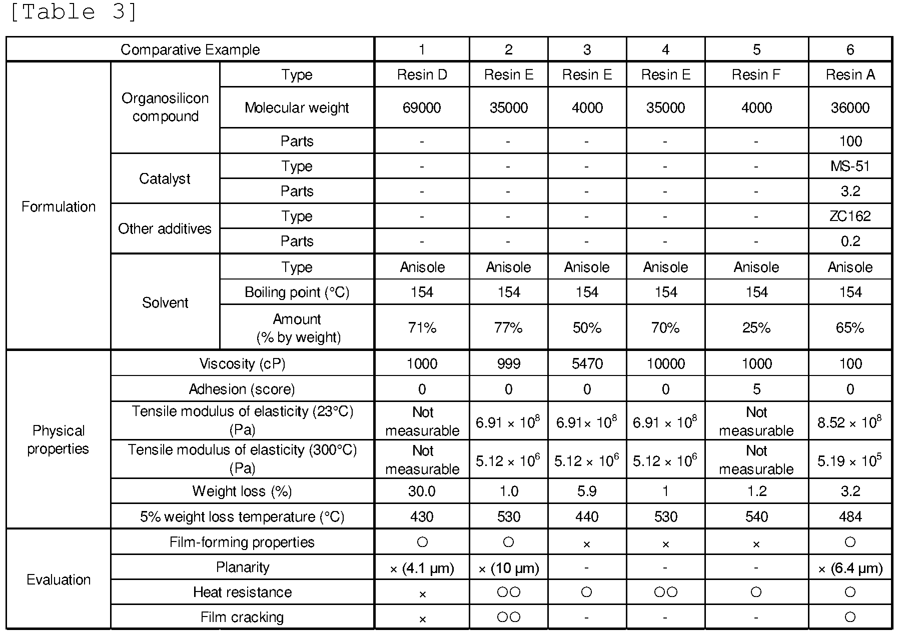

### INDUSTRIAL APPLICABILITY

The present invention can provide a curable resin composition that can planarize bonding surfaces and connect elements without leaving surface voids even when the elements have irregularities on the surface, thus imparting high bonding reliability between the elements, a cured film formed using the curable resin composition, a stack including the cured film, an imaging device including the stack, an semiconductor device including the stack, a method for producing the stack, and a method for producing an element including a bonding electrode for use in production of the stack.

### REFERENCE SIGNS LIST

1 first element
2 second element
3 electrode
4 cured film
5 through-hole
6 inorganic layer
7 barrier metal layer
8 third element
9 chip
10 fourth element
11 supporting substrate

## Claims

1. A curable resin composition comprising:
an organosilicon compound; and
a solvent,
the curable resin composition having a viscosity at 25°C of 2,000 cP or less,
the solvent being contained in an amount of 50% by weight or less in the curable resin composition,
the curable resin composition having an adhesion of a score of 0 to 2 as measured by a cross-cut method in conformity with JIS K5600-5-6 using a measurement sample obtained by spin-coating a silicon wafer with the composition, evaporating the solvent, and then heat curing at 300°C for one hour to form a film.

2. The curable resin composition according to claim 1,
wherein a cured product of the curable resin composition obtained by evaporating the solvent and then curing at 300°C for one hour has a tensile modulus of elasticity at 23°C of 100 MPa or greater and 10 GPa or less, and
the cured product has a tensile modulus of elasticity at 300°C of 10,000 Pa or greater and 1 GPa or less.

3. The curable resin composition according to claim 1 or 2,
wherein a cured product of the curable resin composition obtained by evaporating the solvent and then curing at 300°C for one hour has a weight loss of 6% or less after being heated under a nitrogen atmosphere at 400°C for four hours.

4. The curable resin composition according to any one of claims 1 to 3,
wherein the solvent is contained in an amount of 45% by weight or less, and the viscosity at 25°C is 1,500 cP or less.

5. The curable resin composition according to any one of claims 1 to 4,
wherein the solvent has a boiling point of 150°C or higher and 250°C or lower.

6. The curable resin composition according to any one of claims 1 to 5,
wherein the organosilicon compound has a structure represented by the following formula (1): 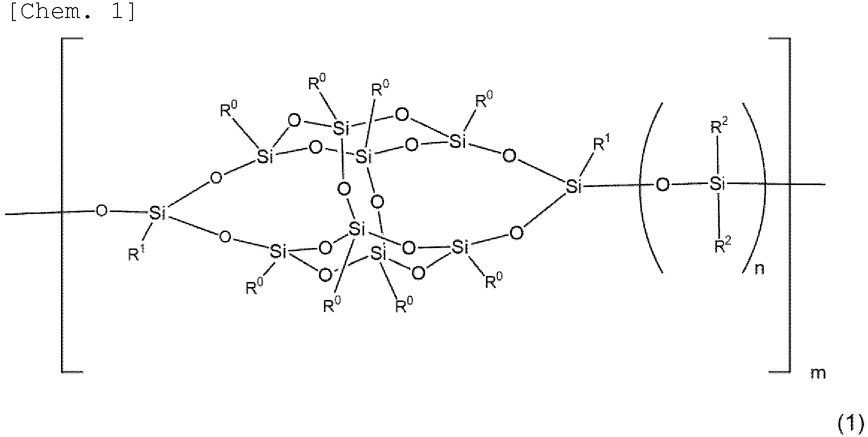
wherein R⁰s, R¹s, and R²s each independently represent a linear, branched, or cyclic aliphatic group, an aromatic group, or hydrogen; the aliphatic group and the aromatic group optionally have a substituent; and m and n each represent an integer of 1 or greater.

7. A curable resin composition comprising:
an organosilicon compound; and
a solvent,
the curable resin composition having a viscosity at 25°C of 2,000 cP or less,
the solvent being contained in an amount of 50% by weight or less in the curable resin composition,
the organosilicon compound having a structure represented by the following formula (1): 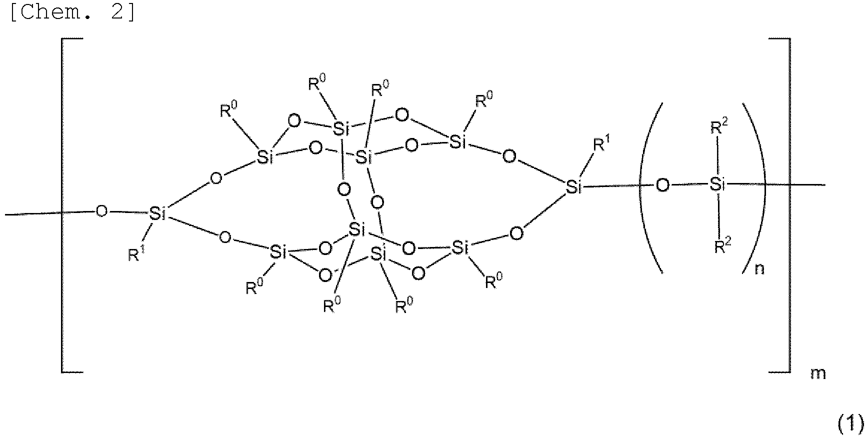
wherein R⁰s, R¹s, and R²s each independently represent a linear, branched, or cyclic aliphatic group, an aromatic group, or hydrogen; the aliphatic group and the aromatic group optionally have a substituent; and m and n each represent an integer of 1 or greater.

8. A cured film formed using the curable resin composition according to any one of claims 1 to 6.

9. The cured film according to claim 8,
wherein the cured film has a weight loss of 6% or less after being heated under a nitrogen atmosphere at 400°C for four hours.

10. A stack comprising:
a first element including an electrode;
a second element including an electrode; and
the cured film according to claim 8 or 9 between the first element and the second element,
the electrode of the first element and the electrode of the second element being electrically connected to each other via a through-hole extending through the cured film.

11. The stack according to claim 10, comprising an inorganic layer between the first element and the second element.

12. The stack according to claim 10 or 11, comprising a barrier metal layer on a surface of the through-hole.

13. An imaging device comprising the stack according to any one of claims 10 to 12.

14. A semiconductor device comprising the stack according to any one of claims 10 to 12.

15. A method for producing a stack, comprising the steps of:
forming cured films by forming a film of the curable resin composition according to any one of claims 1 to 6 on a surface of a first element including an electrode, the surface being a surface on which the electrode is formed, and a film of the curable resin composition on a surface of a second element including an electrode, the surface being a surface on which the electrode is formed, evaporating the solvent, and then curing the films;
forming a through-hole in each of the cured films;
filling each of the through-holes with a conductive material;
forming bonding electrodes by polishing the surface of the first element on the side where the through-hole is filled with the conductive material and the surface of the second element on the side where the through-hole is filled with the conductive material; and
bonding the first element on which the bonding electrode is formed and the second element on which the bonding electrode is formed such that the bonding electrodes are bonded to each other.

16. A method for producing an element including a bonding electrode, comprising the steps of:
forming a cured film by forming a film of the curable resin composition according to any one of claims 1 to 6 on a surface of an element including an electrode, the surface being a surface on which the electrode is formed, evaporating the solvent, and then curing the film;
forming a through-hole in the cured film;
filling the through-hole with a conductive material; and
forming a bonding electrode by polishing the surface of the element.

17. A stack comprising:
a supporting substrate;
a third element; and
the cured film according to claim 8 or 9 between the supporting substrate and the third element,
the third element having a first surface and a second surface and including a plurality of chips stacked on the first surface, the chips being electrically connected to the third element,
the cured film being provided between the first surface and the supporting substrate.

18. The stack according to claim 17, comprising an inorganic layer between the supporting substrate and the cured film.

19. The stack according to claim 17 or 18, further comprising a fourth element on the second surface of the third element,
wherein the third element and the fourth element are electrically connected to each other.

20. An imaging device comprising the stack according to any one of claims 17 to 19.

21. A semiconductor device comprising the stack according to any one of claims 17 to 19.
